(19) Europäisches Patentamt
European Patent Office
Office européen des brevets

(11) **EP 4 460 165 A1**

(12) **EUROPEAN PATENT APPLICATION**
published in accordance with Art. 153(4) EPC

(43) Date of publication:
**06.11.2024 Bulletin 2024/45**

(21) Application number: **22956709.4**

(22) Date of filing: **29.08.2022**

(51) International Patent Classification (IPC):
***H10K 50/115*** (2023.01)

(52) Cooperative Patent Classification (CPC):
**H10K 50/115**

(86) International application number:
**PCT/CN2022/115412**

(87) International publication number:
**WO 2024/044873 (07.03.2024 Gazette 2024/10)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **BOE Technology Group Co., Ltd.
Beijing 100015 (CN)**

• **Beijing BOE Technology Development Co., Ltd.
Beijing 100176 (CN)**

(72) Inventor: **ZHANG, Xiaoyuan
Beijing 100176 (CN)**

(74) Representative: **Hoffmann Eitle
Patent- und Rechtsanwälte PartmbB
Arabellastraße 30
81925 München (DE)**

(54) **LIGHT-EMITTING DEVICE, MANUFACTURING METHOD THEREFOR, DISPLAY PANEL AND DISPLAY DEVICE**

(57)    A light-emitting device is provided. The light-emitting device comprises a first electrode, an electron transport and adjustment layer, a quantum dot light-emitting layer and a second electrode which are sequentially stacked. The electron transport and adjustment layer is configured to adjust the number of electrons transported by the first electrode to the quantum dot light-emitting layer.

100

FIG. 4A-1

Processed by Luminess, 75001 PARIS (FR)

**Description**

TECHNICAL FIELD

The present disclosure relates to the field of display technologies, and in particular, to a light-emitting device and a method for manufacturing the same, a display panel and a display apparatus.

BACKGROUND

Quantum dot light-emitting diode (QLED) devices have advantages such as high color gamut, self-illumination, low starting voltage and quick response, thereby gaining wide attention in the display field. A basic working principle of a quantum dot light-emitting diode device is that, electrons and holes are injected into opposite sides of a quantum dot light-emitting layer, the electrons combine with the holes in the quantum dot light-emitting layer to form excitons, and then radiative recombination occurs to cause light emission.

SUMMARY

In an aspect, a light-emitting device is provided. The light-emitting device includes a first electrode, an electron transport adjustment layer, a quantum dot light-emitting layer and a second electrode that are arranged in sequence. The electron transport adjustment layer is configured to adjust a number of electrons transported from the first electrode to the quantum dot light-emitting layer.

In some embodiments, the electron transport adjustment layer includes an electron transport layer located between the first electrode and the quantum dot light-emitting layer and an electron adjustment layer located between the electron transport layer and the first electrode. A work function of the electron adjustment layer is greater than a work function of the electron transport layer, and the work function of the electron adjustment layer is greater than a work function of the first electrode, and the electron adjustment layer is configured to reduce the number of electrons transported from the first electrode to the quantum dot light-emitting layer.

In some embodiments, the electron adjustment layer and the electron transport layer together include at least three elements, and the electron adjustment layer and the electron transport layer include at least one same element.

In some embodiments, the work function of the electron adjustment layer is E eV, and a thickness of the electron adjustment layer is D nm, where E and D satisfy:

$$1 < \frac{E}{D} < 23.33 \ .$$

In some embodiments, the work function of the electron adjustment layer is in a range of 5 eV to 7 eV, inclusive.

In some embodiments, an energy level of a highest occupied molecular orbital of the electron adjustment layer is in a range of -7 eV to -10 eV, inclusive; and an energy of a lowest unoccupied molecular orbital of the electron adjustment layer is in a range of -4.2 eV to -6 eV, inclusive.

In some embodiments, a material of the electron adjustment layer includes an oxide of a metal of a fifth sub-group or an oxide of a metal of a sixth sub-group.

In some embodiments, a material of the electron adjustment layer includes at least one of $MoO_3$, $WO_3$, $V_2O_5$ or $CrO_3$; and a material of the electron transport layer includes at least one of ZnO, ZnS, ZnSe, ZnMgO, NiO, CdS, CdSe or CdO.

In some embodiments, an energy level of a lowest unoccupied molecular orbital of the electron transport adjustment layer is less than an energy level of a lowest unoccupied molecular orbital of the electron transport layer.

In some embodiments, a roughness of a surface of the electron adjustment layer away from the electron transport layer is less than a roughness of a surface of the electron transport layer away from the electron adjustment layer.

In some embodiments, the electron transport layer includes an electron transport layer located between the first electrode and the quantum dot light-emitting layer and an electron adjustment layer located between the electron transport layer and the first electrode. A work function of the electron adjustment layer is less than a work function of the electron transport layer, and the work function of the electron adjustment layer is less than a work function of the first electrode. The electron adjustment layer is configured to increase the number of electrons transported from the first electrode to the quantum dot light-emitting layer.

In some embodiments, a material of the electron adjustment layer includes $Cs_2O_3$.

In some embodiments, a thickness of the electron adjustment layer is in a range of 0.3 nm to 5 nm, inclusive.

In some embodiments, the electron transport adjustment layer includes a dopant material and a host material.

The dopant material is configured to adjust the number of electrons transported from the first electrode to the quantum dot light-emitting layer.

In some embodiments, the electron transport adjustment layer includes at least three elements, and the dopant material and the host material include at least one same element.

In some embodiments, a work function of the dopant material is greater than a work function of the host material, and the work function of the dopant material is greater than a work function of the first electrode. The dopant material is configured to reduce the number of electrons transported from the first electrode to the quantum dot light-emitting layer.

In some embodiments, the dopant material includes a P-type dopant material.

In some embodiments, the P-type dopant material includes at least one of $MoO_3$, $WO_3$, $V_2O_5$ or $CrO_3$.

In some embodiments, the light-emitting device further includes a hole transport layer located between the second electrode and the quantum dot light-emitting layer and a hole injection layer located between the second electrode and the hole transport layer.

In another aspect, a method for manufacturing a light-emitting device is provided. The method for manufacturing the light-emitting device includes: forming an electron transport adjustment layer on a side of a first electrode, forming a quantum dot light-emitting layer on a side of the electron transport adjustment layer away from the first electrode, and forming a second electrode on a side of the quantum dot light-emitting layer away from the electron transport adjustment layer; or forming the quantum dot light-emitting layer on a side of the second electrode, forming the electron transport adjustment layer on a side of the quantum dot light-emitting layer away from the second electrode, and forming the first electrode on a side of the electron transport adjustment layer away from the quantum dot light-emitting layer. The electron transport adjustment layer is configured to adjust a number of electrons transported from the first electrode to the quantum dot light-emitting layer.

In some embodiments, forming the electron transport adjustment layer on the side of the first electrode includes: forming an electron adjustment layer by evaporation, and forming an electron transport layer on a side of the electron adjustment layer away from the first electrode; or forming the electron transport layer on the side of the quantum dot light-emitting layer away from the second electrode, and forming the electron adjustment layer on a side of the electron transport layer away from the quantum dot light-emitting layer by evaporation.

In some embodiments, forming the electron transport adjustment layer on the side of the first electrode includes: forming the electron transport adjustment layer on the side of the first electrode by a solution process; or forming the electron transport adjustment layer on the side of the quantum dot light-emitting layer away from the second electrode by a solution process. The electron transport adjustment layer includes a dopant material and a host material, and the dopant material is configured to adjust the number of electrons transported from the first electrode to the quantum dot light-emitting layer.

In yet another aspect, a display panel is provided. The display panel includes a backplane and a plurality of light-emitting devices as described in any one of the above embodiments. The plurality of light-emitting devices are disposed on a side of the backplane.

In some embodiments, a first electrode of a light-emitting device is closer to the backplane than a second electrode of the light-emitting device; or the second electrode of the light-emitting device is closer to the backplane than the first electrode of the light-emitting device.

In another aspect, a display apparatus is provided. The display apparatus includes the display panel as described in any one of the above embodiments.

BRIEF DESCRIPTION OF THE DRAWINGS

In order to describe technical solutions in the present disclosure more clearly, accompanying drawings to be used in some embodiments of the present disclosure will be introduced briefly below. However, the accompanying drawings to be described below are merely accompanying drawings of some embodiments of the present disclosure, and a person having ordinary skill in the art can obtain other drawings according to these accompanying drawings. In addition, the accompanying drawings in the following description may be regarded as schematic diagrams, but are not limitations on an actual size of a product, an actual process of a method and an actual timing of a signal involved in the embodiments of the present disclosure.

FIG. 1 is a structural diagram of a display apparatus, in accordance with some embodiments;
FIG. 2 is a top view structural view of a display panel, in accordance with some embodiments;
FIG. 3 is a section of a display panel, in accordance with some embodiments;
FIG. 4A-1 is a structural diagram of a light-emitting device, in accordance with some embodiments;

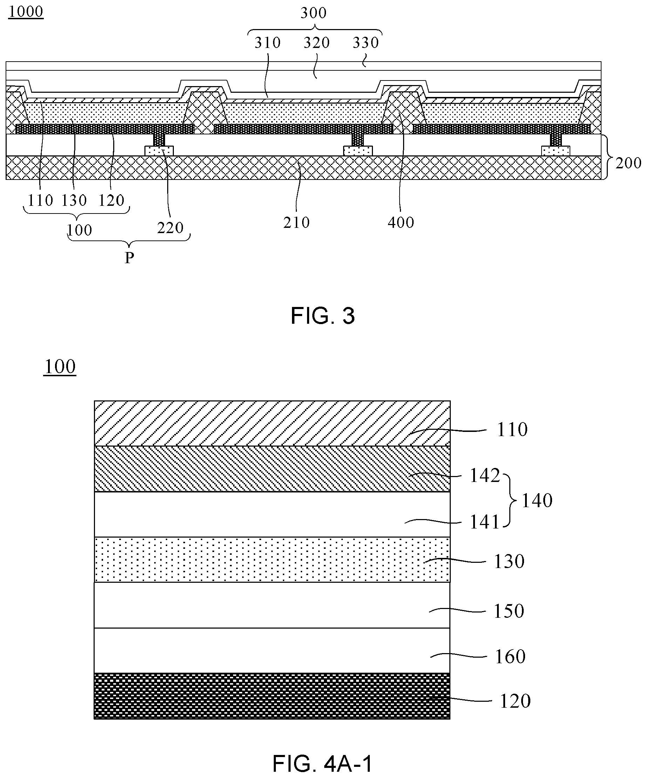

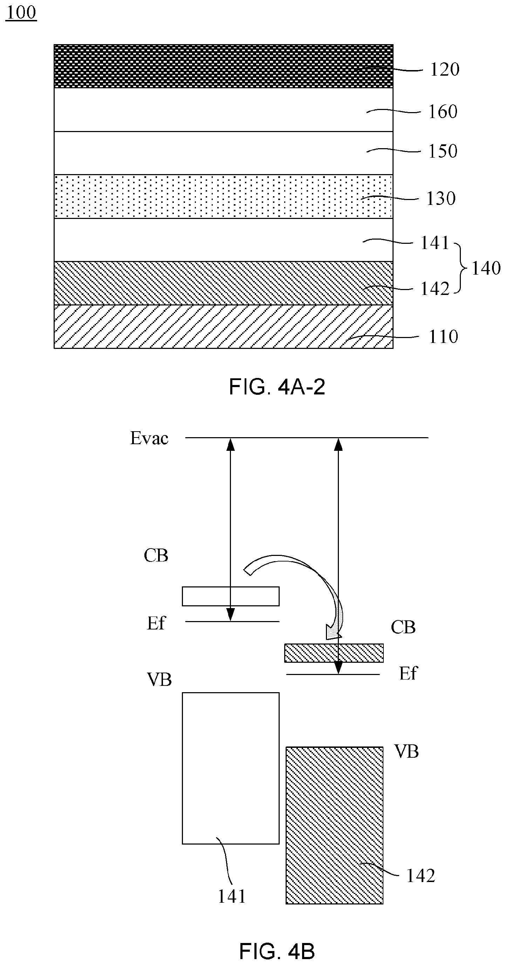

FIG. 4A-2 is a structural diagram of another light-emitting device, in accordance with some embodiments;
FIG. 4B is a diagram showing an energy level structure of a light-emitting device, in accordance with some embodiments;

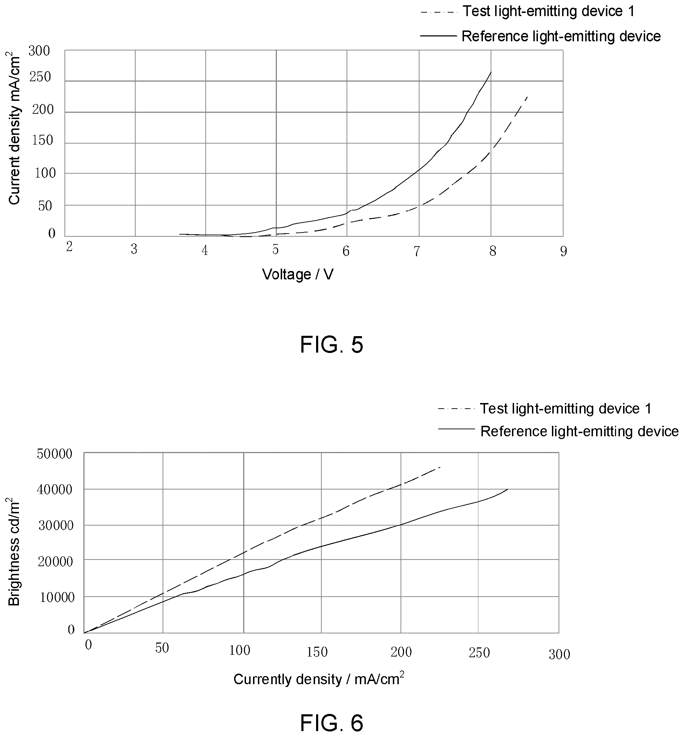

FIG. 5 is a schematic diagram showing variations of current density versus voltage, in accordance with some embodiments;

FIG. 6 is a schematic diagram showing variations of brightness of light-emitting devices versus voltage, in accordance with some embodiments;

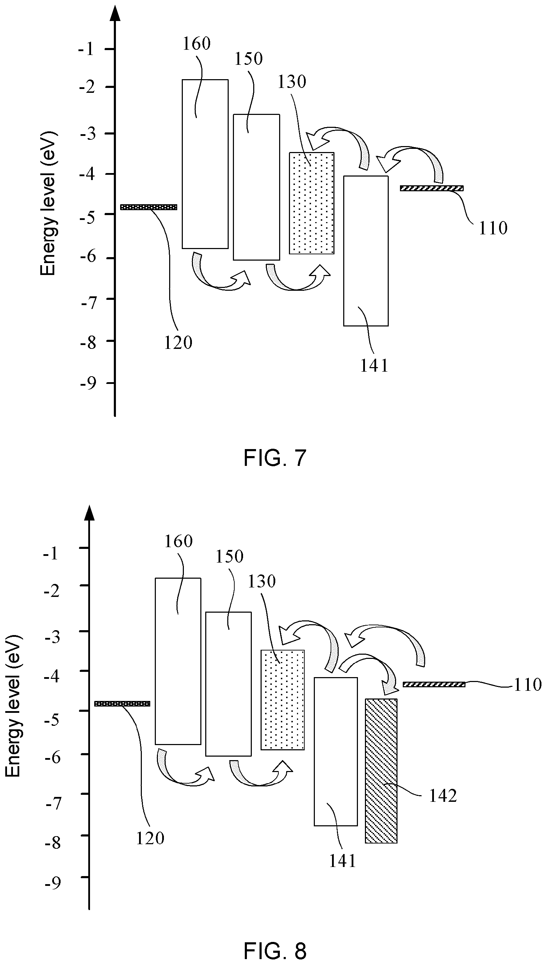

FIG. 7 is a schematic diagram showing another variation of current density versus voltage, in accordance with some embodiments;

FIG. 8 is a schematic diagram showing yet another variation of current density versus voltage, in accordance with some embodiments;

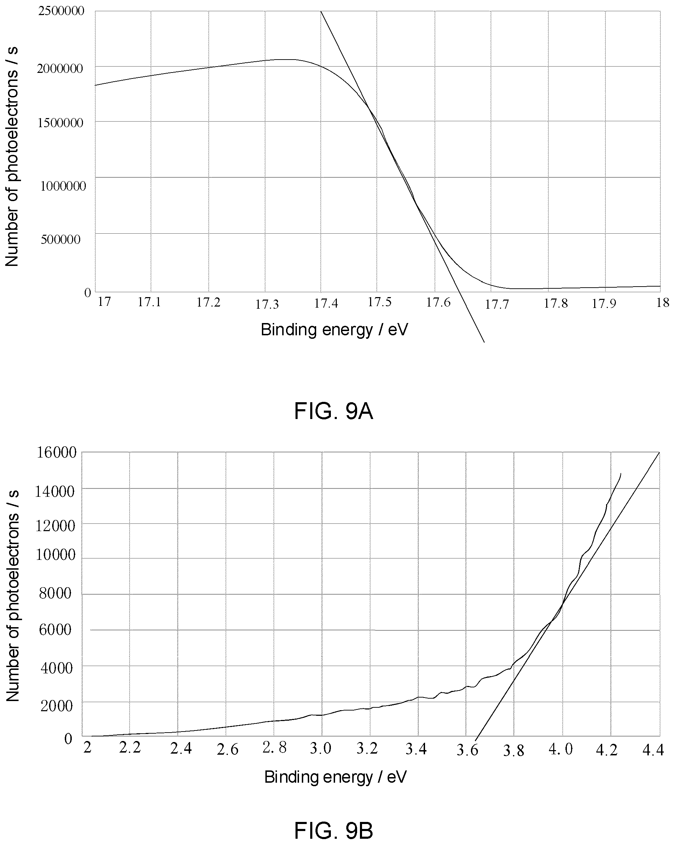

FIG. 9A is a schematic diagram showing a variation of binding energy of an electron transport adjustment layer, in accordance with some embodiments;

FIG. 9B is a schematic diagram showing a variation of binding energy of another electron transport adjustment layer, in accordance with some embodiments;

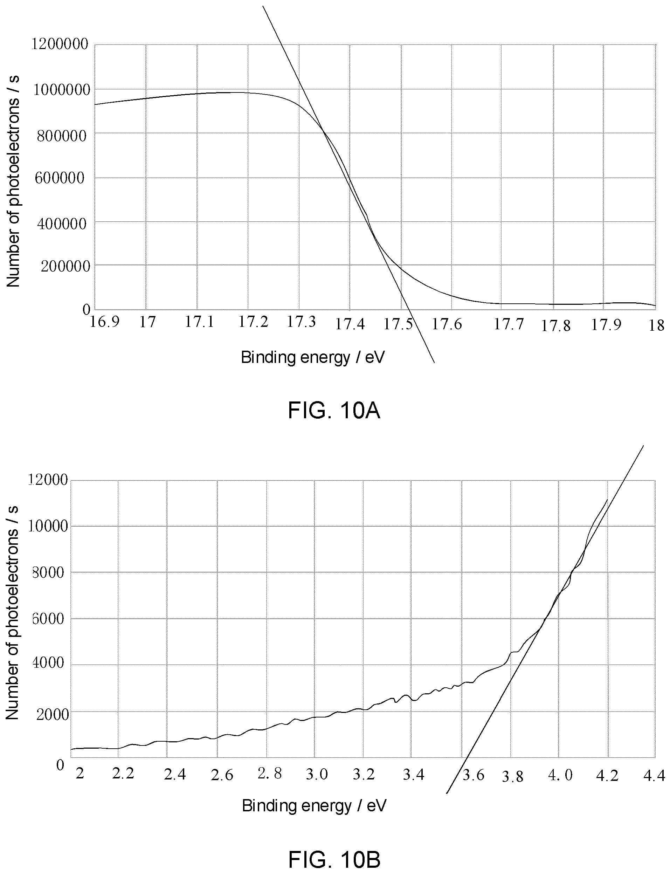

FIG. 10A is a schematic diagram showing a variation of binding energy of yet another electron transport adjustment layer, in accordance with some embodiments;

FIG. 10B is a schematic diagram showing a variation of binding energy of yet another electron transport adjustment layer, in accordance with some embodiments;

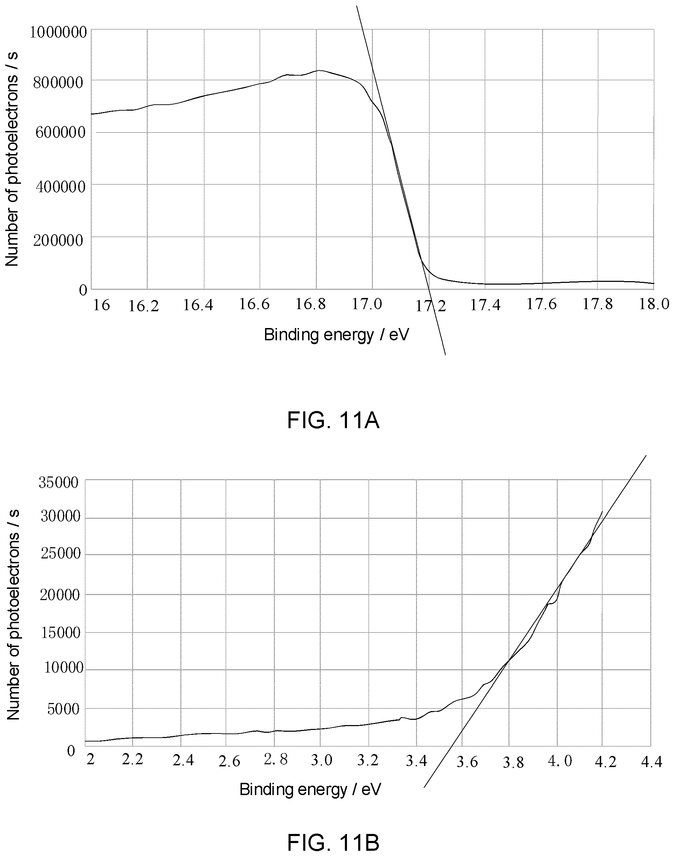

FIG. 11A is a schematic diagram showing a variation of binding energy of yet another electron transport adjustment layer, in accordance with some embodiments;

FIG. 11B is a schematic diagram showing a variation of binding energy of yet another electron transport adjustment layer, in accordance with some embodiments;

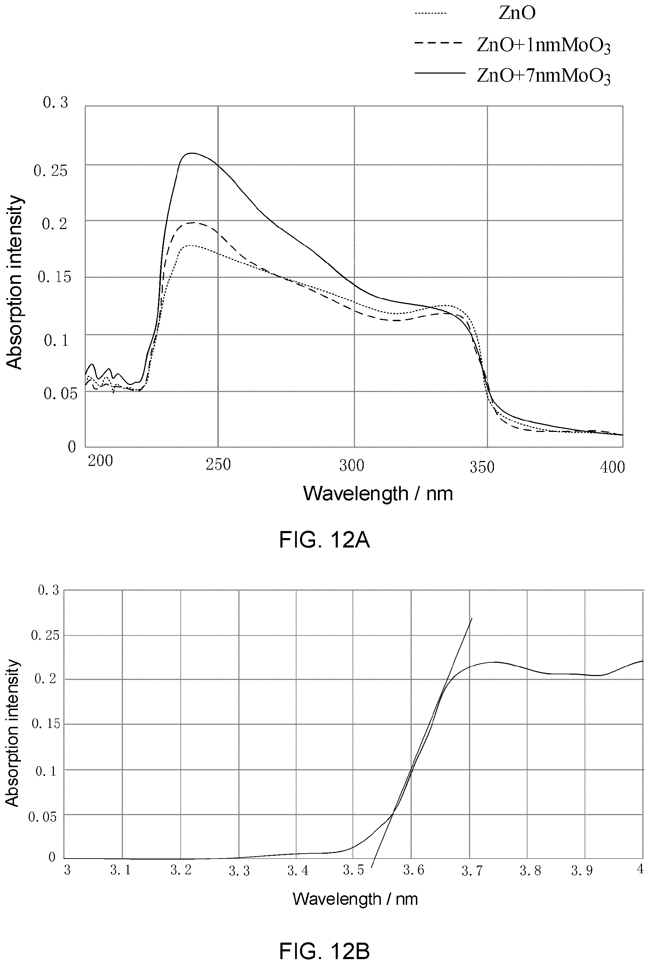

FIG. 12A shows ultraviolet-visible (UV-visible) absorption spectrograms of electron transport adjustment layers, in accordance with some embodiments;

FIG. 12B shows a UV-visible absorption spectrogram of an electron transport adjustment layer, in accordance with some embodiments;

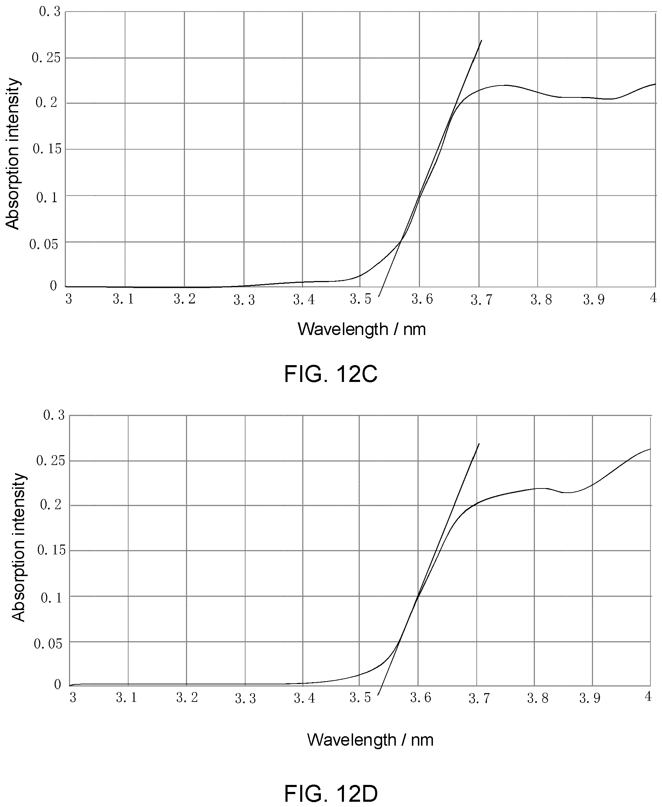

FIG. 12C shows a UV-visible absorption spectrogram of another electron transport adjustment layer, in accordance with some embodiments;

FIG. 12D shows a UV-visible absorption spectrogram of yet another electron transport adjustment layer, in accordance with some embodiments;

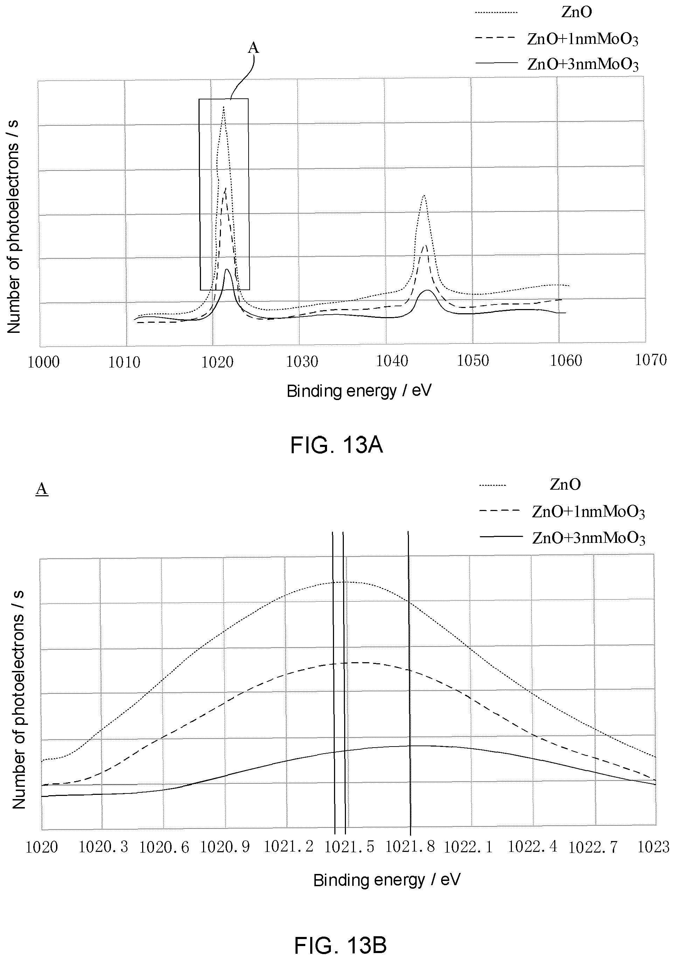

FIG. 13A is a schematic diagram showing variations of binding energy of some electron transport adjustment layers, in accordance with some embodiments;

FIG. 13B is a schematic diagram showing variations of binding energy of some other electron transport adjustment layers, in accordance with some embodiments;

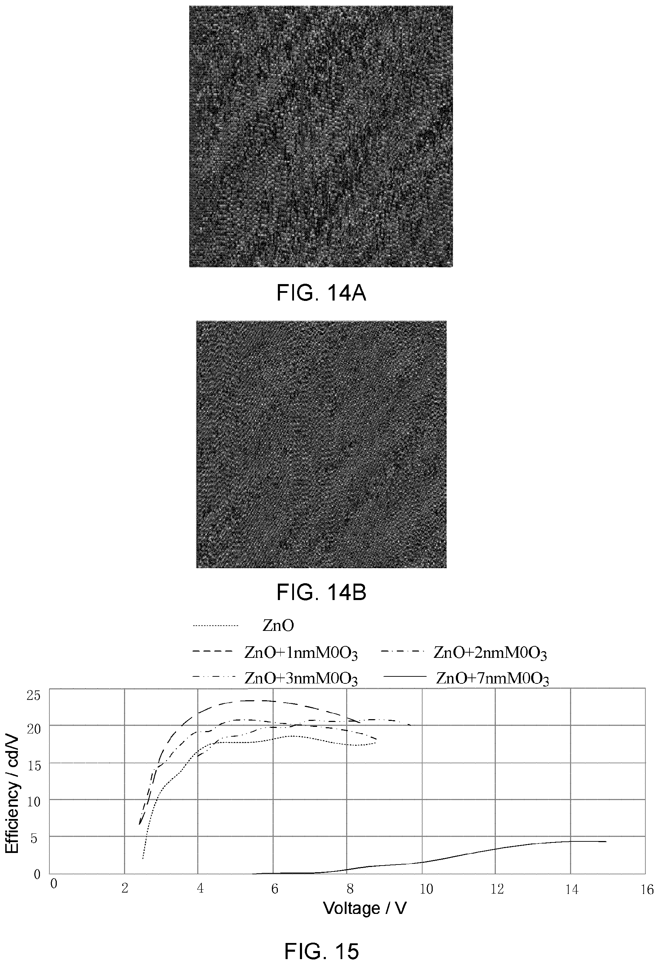

FIG. 14A shows a film-layer electron micrograph of an electron transport adjustment layer, in accordance with some embodiments;

FIG. 14B shows a film-layer electron micrograph of another electron transport adjustment layer, in accordance with some embodiments;

FIG. 15 is a schematic diagram showing variations of current efficiency versus voltage, in accordance with some embodiments;

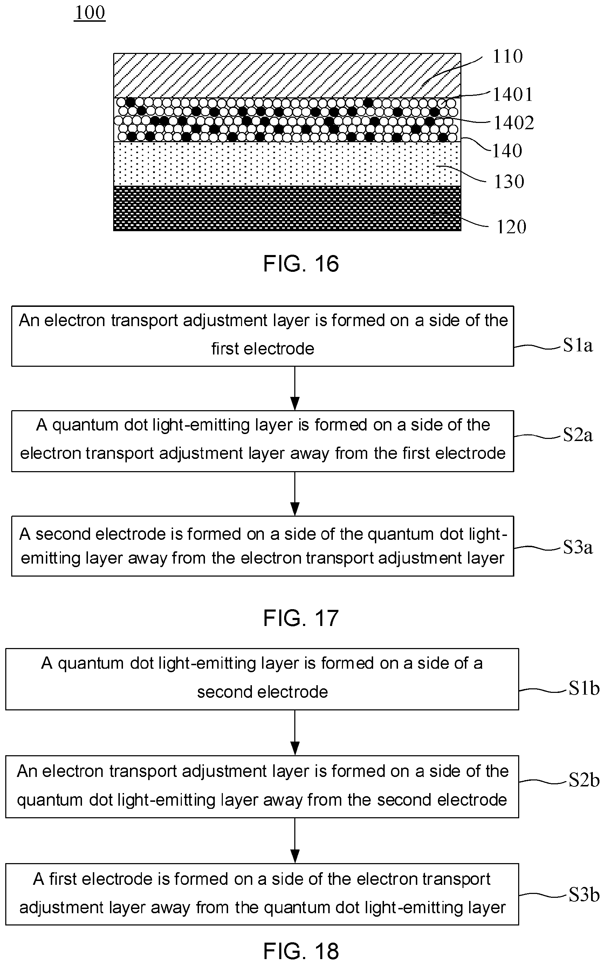

FIG. 16 is a structural diagram of yet another light-emitting device, in accordance with some embodiments;

FIG. 17 is a flowchart of a method for manufacturing a light-emitting device, in accordance with some embodiments; and

FIG. 18 is a flowchart of another method for manufacturing a light-emitting device, in accordance with some embodiments.

## DETAILED DESCRIPTION

Technical solutions in some embodiments of the present disclosure will be described clearly and completely below with reference to the accompanying drawings. However, the described embodiments are merely some but not all embodiments of the present disclosure. All other embodiments obtained by a person of ordinary skill in the art based on the embodiments of the present disclosure shall be included in the protection scope of the present disclosure.

Unless the context requires otherwise, throughout the description and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representation of the above terms does not necessarily refer to the same embodiment(s) or example(s). In addition, the specific features, structures, materials or characteristics may be included in any one or more embodiments or examples in any suitable manner.

Hereinafter, the terms such as "first" and "second" are used for descriptive purposes only, but are not to be construed as indicating or implying the relative importance or implicitly indicating the number of indicated technical features. Thus, the features defined with "first" and "second" may explicitly or implicitly include one or more of the features. In the description of the embodiments of the present disclosure, the term "a plurality of / the plurality of" means two or more unless otherwise specified.

Some embodiments may be described using the terms "coupled" and "connected" and their derivatives. For example, the term "connected" may be used in the description of some embodiments to indicate that two or more components are in direct physical or electrical contact with each other. For another example, the term "coupled" may be used in the description of some embodiments to indicate that two or more components are in direct physical or electrical contact. However, the term "coupled" or "communicatively coupled" may also mean that two or more components are not in direct contact with each other, but still cooperate or interact with each other. The embodiments disclosed herein are not necessarily limited to the content herein.

The phrase "at least one of A, B and C" has a same meaning as the phrase "at least one of A, B or C", and they both include the following combinations of A, B and C: only A, only B, only C, a combination of A and B, a combination of A and C, a combination of B and C, and a combination of A, B and C.

The phrase "A and/or B" includes the following three combinations: only A, only B, and a combination of A and B.

As used herein, the term "if" is optionally construed as "when" or "in a case where" or "in response to determining that" or "in response to detecting" depending on the context. Similarly, depending on the context, the phrase "if it is determined" or "if [a stated condition or event] is detected" is optionally construed as "in a case where it is determined", "in response to determining", "in a case where [the stated condition or event] is detected", or "in response to detecting [the stated condition or event]".

In addition, the use of the phrase "based on" is meant to be open and inclusive, since a process, step, calculation or other action that is "based on" one or more of the stated conditions or values may, in practice, be based on additional conditions or values exceeding those stated.

Terms such as "about", "substantially" or "approximately" as used herein include a stated value and an average value within an acceptable range of deviation of a particular value. The acceptable range of deviation is determined by a person of ordinary skill in the art in view of the measurement in question and the error associated with the measurement of a particular quantity (i.e., the limitations of the measurement system).

As used herein, the terms such as "parallel", "perpendicular" or "equal" include a stated case and a case similar to the stated case. The similar case is within an acceptable range of deviation, and the acceptable range of deviation is determined by a person of ordinary skill in the art in view of measurement in question and errors associated with measurement of a particular quantity (i.e., limitations of a measurement system). For example, the term "parallel" includes absolute parallelism and approximate parallelism, and an acceptable range of deviation of the approximate parallelism may be a deviation within 5°. For example, the term "perpendicular" includes absolute perpendicularity and approximate perpendicularity, and an acceptable range of deviation of the approximate perpendicularity may be a deviation within 5°. For example, the term "equal" includes absolute equality and approximate equality, and an acceptable range of deviation of the approximate equality may refer to that, a difference between two equals is less than or equal to 5% of either of the two equals.

It will be understood that, in a case where a layer or a component is described as being on another layer or a substrate, it may be that the layer or the component is directly on the another layer or the substrate, or that intermediate layer(s) exist between the layer the component and the another layer or the substrate.

Exemplary embodiments are described herein with reference to sectional views and/or plan views as idealized exemplary drawings. In the accompanying drawings, thicknesses of layers and areas of regions are enlarged for clarity. Thus, variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown in a rectangular shape generally has a feature of being curved. Therefore, the regions shown in the accompanying drawings are schematic in nature, and their shapes are not intended to show actual shapes of the region in a device, and are not intended to limit the scope of the exemplary embodiments.

As a new type of light-emitting material, quantum dots (QDs) have advantages such as high luminous color purity, high light-emitting quantum yield, adjustable light-emitting color and long service life, and have become a current research hotspot for light-emitting materials of new types of light-emitting diodes (LEDs). Therefore, quantum dot light-emitting diodes (QLEDs) using quantum dot materials as light-emitting layers have become a main direction of current research on new types of display devices.

A basic working principle of a quantum dot light-emitting diode is that, electrons and holes are respectively inject into opposite sides of a quantum dot light-emitting layer, the electrons combine with the holes in the quantum dot light-emitting layer to form excitons, and then radiative recombination occurs to cause light emission.

However, the electrons and the holes have different injection rates. An imbalance between injection rates of the electrons and the holes into the quantum dot light-emitting layer leads to that, a number of electrons injected into the quantum dot light-emitting layer is different from a number of holes injected into the quantum dot light-emitting layer. Consequently, a light-emitting efficiency and a service life of the light-emitting device are reduced.

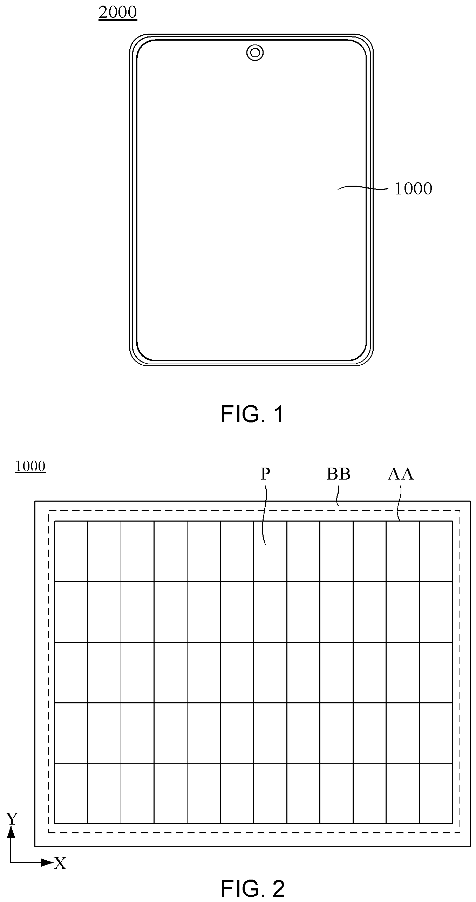

With reference to FIG. 1, some embodiments of the present disclosure provide a display apparatus 2000. The display apparatus 2000 includes a display panel 1000.

In some examples, the display apparatus 2000 may be a quantum dot light-emitting diode (QLED) display apparatus.

For example, the display apparatus 2000 further includes a frame, a display driver integrated circuit (IC) and other electronic components.

For example, the display apparatus 2000 may be any apparatus that displays images whether in motion (e.g., videos) or stationary (e.g., still images) and whether text or images. More specifically, it is anticipated that the embodiments may be implemented in a variety of electronic apparatuses or associated with a variety of electronic apparatuses. The variety of electronic apparatuses include (but are not limited to) a mobile phone, a wireless apparatus, a personal digital assistant (PDA), a hand-held or portable computer, a global positioning system (GPS) receiver/navigator, a camera, an moving picture experts group 4 (MP4) video player, a video camera, a game console, a watch, a clock, a calculator, a television monitor, a flat panel display, a computer monitor, an automobile display (e.g., an odometer display), a navigator, a cockpit controller and/or display, a display of camera views (e.g., a display of a rear-view camera in a vehicle), an electronic photo, an electronic billboard or sign, a projector, a building structure, a packaging and aesthetic structure (e.g., a display for displaying an image of a piece of jewelry), etc.

In some embodiments, with reference to FIG. 2, the display panel 1000 has a display area AA and a peripheral area BB located on at least one side of the display area AA.

In some examples, with reference to FIG. 2, the peripheral area BB is disposed around the display area AA.

The display area AA is an area for displaying images. The display area AA is provided therein with sub-pixels P of a plurality of colors. The sub-pixels P of the plurality of colors at least include sub-pixels of a first color, sub-pixels of a second color and sub-pixels of a third color. The first color, the second color and the third color are three primary colors (e.g., a red color, a green color and a blue color). The peripheral area BB is an area in which structures such as a scan driver circuit, circuit traces and bonding pins are provided.

For example, with reference to FIG. 2, a plurality of sub-pixels P are arranged in a plurality of rows and a plurality of columns. Each row of sub-pixels P may include multiple sub-pixels P arranged along a second direction X, and each column of sub-pixels P may include multiple sub-pixels P arranged along a first direction Y.

In some embodiments, with reference to FIG. 3, the display panel 1000 includes a backplane (BP for short) 200, light-emitting devices 100 and an encapsulation layer 300 that are arranged in sequence.

The backplane 200 includes a substrate 210 and a plurality of pixel driving circuits 220. The plurality of pixel driving circuits 220 are disposed on the substrate 210.

In some examples, a type of the substrate 210 varies, which may be determined depending on actual needs.

For example, the substrate 210 may be a rigid substrate. A material of the rigid substrate may include, for example, glass, quartz or plastic.

For example, the substrate 210 may be a flexible substrate. A material of the flexible substrate may include, for example, polyethylene terephthalate (PET), polyethylene naphthalate two formic acid glycol ester (PEN) or polyimide (PI).

In some examples, each sub-pixel P includes a light-emitting device 100 and a pixel driving circuit 220.

Here, the pixel driving circuit 220 is generally composed of electronic devices such as thin film transistor(s) (TFT)(s) and capacitor(s). For example, the pixel driving circuit may a pixel driving circuit with a 2T1C structure composed of two TFTs (e.g., including one switching TFT and one driving TFT) and one capacitor. Of course, the pixel driving circuit 220 may also be a pixel driving circuit 220 including more than two TFTs (e.g., including a plurality of switching TFTs and one driving TFT) and at least one capacitor.

For example, the pixel driving circuits 220 are electrically connected to the light-emitting devices 100. Here, a connection relationship therebetween varies, which may be determined depending on actual needs.

For an example, the first pixel circuits 220 are electrically connected to the first light-emitting devices 100 in a one-to-one correspondence. For another example, a single pixel driving circuit 220 may be electrically connected to multiple light-emitting devices 100. For yet another example, multiple pixel driving circuits are electrically connected to a single light-emitting device 100.

A structure of the display panel 1000 is schematically described by taking an example where the pixel driving circuits 220 are electrically connected to the first light-emitting devices 100 in a one-to-one correspondence.

It will be understood that, the pixel driving circuit 220 can generate a driving signal and transmit the driving signal to a corresponding light-emitting device 100, so that a light-emitting state of the light-emitting device 100 is controlled. The light-emitting state includes, for example, whether the light-emitting device 100 emits light, or a light-emitting brightness of the light-emitting device 100. The plurality of pixel driving circuits 220 control light-emitting states of a plurality of light-emitting devices 100, so that the display panel 1000 display an image.

Here, the light-emitting device 100 includes a first electrode 110, a second electrode 120 and a quantum dot light-emitting layer 130 located between the first electrode 110 and the second electrode 120.

Here, the first electrode 110 is an anode, and the second electrode 120 is a cathode. When voltages are respectively applied to the first electrode 110 and the second electrode 120, an electric field may be generated between the first electrode 110 and the second electrode 120, the electric field may drive electrons and holes to move and combined with each other to form excitons in the quantum dot light-emitting layer 130, and the excitons undergo radiative transitions to emit light, so that a luminescence phenomenon is produced. That is, electroluminescence is achieved.

Here, the encapsulation layer 300 may include a first inorganic encapsulation film 310, an organic encapsulation film 320 and a second inorganic encapsulation film 330. In some examples, each of the first inorganic encapsulation film 310 and the second inorganic encapsulation film 330 may be made of silicon nitride, aluminum nitride, zirconium nitride, titanium nitride, hafnium nitride, tantalum nitride, silicon oxide, aluminum oxide, titanium oxide, tin oxide, cerium oxide, silicon oxynitride (SiON), lithium fluoride, etc. In some examples, the organic encapsulation film 320 may be made of an acrylic resin, a methacrylic resin, polyisoprene, a vinyl resin, an epoxy resin, a urethane resin, a cellulose resin, etc.

In addition, the display panel 1000 further includes a pixel defining layer 400. The pixel defining layer 400 is located on a side of the plurality of pixel driving circuits 220 away from the substrate 210. The pixel defining layer 400 is provided with a plurality of openings. At least a portion of a quantum dot light-emitting layer 130 of a light-emitting device 100 is located in an opening, and the opening defines a light-emitting area of the corresponding light-emitting device 100.

Some embodiments of the present disclosure provide a light-emitting device 100. The light-emitting device 100 may be applied to the display panel 1000 described above. Of course, the light-emitting device 100 may also be applied to other display panels 1000.

For example, with reference to FIGS. 4A-1 and 4A-2, the light-emitting device 100 includes the first electrode 110, the second electrode 120 and the quantum dot light-emitting layer 130 located between the first electrode 110 and the second electrode 120.

In some examples, the first electrode 110 is closer to the backplane 200 than the second electrode 120, and the first electrode 110 is electrically connected to the pixel driving circuit 220. In this case, the light-emitting device 100 has an inverted structure as shown in FIG. 4A-2.

In some other examples, the second electrode 120 is closer to the backplane 200 than the first electrode 110, and the second electrode 120 is electrically connected to the pixel driving circuit 220. In this case, the light-emitting device 100 is in an upright structure as shown in FIG. 4A-1.

Here, a material of the first electrode 110 may be a transparent material or a non-transparent material. In a case where the material of the first electrode 10 is a transparent material, the first electrode 10 may be formed by using, for example, a transparent metal oxide such as indium tin oxide (ITO), indium zinc oxide (IZO), zinc oxide (ZnO) and/or indium tin zinc oxide (ITZO). In a case where the material of the first electrode 110 is a non-transparent material, the material of the first electrode 10 may include silver (Ag), magnesium (Mg), copper (Cu), aluminum (Al), platinum (Pt), and palladium (Pd), gold (Au), nickel (Ni), neodymium (Nd), iridium (Ir), chromium (Cr), lithium (Li), calcium (Ca), Ca-LiF alloy, Al-LiF alloy, molybdenum (Mo) or titanium (Ti) or complex thereof or mixtures thereof (e.g., a mixture of Ag and Mg).

Here, the first electrode 110 has a single-layer structure or a multilayer structure. Embodiments of the present disclosure do not limit this.

A material of the second electrode 120 may include silver (Ag), magnesium (Mg), ytterbium (Yb), lithium (Li) or calcium (Ca). The material of the second electrode 120 may alternatively include lithium oxide ($Li_2O$), Calcium oxide (CaO), lithium fluoride (LiF) or magnesium fluoride ($MgF_2$). The material of the second electrode 120 may alternatively include indium gallium zinc oxide (such as ITO, IZO or IGZO), etc.

The light-emitting layer 120 has a single-layer structure or a multilayer structure. Embodiments of the present disclosure do not limit this.

For example, a material of the quantum dot light-emitting layer 130 may include CdS, CdSe, CdTe, ZnSe, InP, PbS, $CuInS_2$, ZnO, $CsPbCl_3$, $CsPbBr_3$, $CsPhI_3$, CdS/ZnS, CdSe/ZnS, ZnSe, InP/ZnS, PbS /ZnS, InAs, InGaAs, InGaN, GaNk, ZnTe, Si, Ge or C or other nanoscale materials, e.g., nanorods or nanosheets, with the component(s) listed above. Preferably, the material of the quantum dot light-emitting layer 130 includes cadmium-free quantum dots.

In some examples, with continued reference to FIGS. 4A-1 and 4A-2, the light-emitting device 100 further includes an electron transport adjustment layer 140.

Here, the electron transport adjustment layer 140 is located between the first electrode 110 and the quantum dot light-emitting layer 130.

Here, the electron transport adjustment layer 140 is configured to adjust a number of electrons transported from the first electrode 110 to the quantum dot light-emitting layer 130.

In some examples, the electron transport adjustment layer 140 is configured to reduce the number of electrons transported from the first electrode 110 to the quantum dot light-emitting layer 130.

For example, an injection rate of electrons is greater than an injection rate of holes, which results in electrons in the quantum dot light-emitting layer 130 are more than holes in the quantum dot light-emitting layer 130. By providing the electron transport adjustment layer 140, the number of electrons transported from the first electrode 110 to the quantum dot light-emitting layer 130 is reduced. In this way, it may be possible to effectively promote a balance between electrons and holes in the quantum dot light-emitting layer 130, which may effectively improve a light-emitting efficiency, a stability and a service life of the light-emitting device 100.

In some examples, the electron transport adjustment layer 140 is configured to increase the number of electrons transported from the first electrode 110 to the quantum dot light-emitting layer 130.

For example, the injection rate of holes is greater than the injection rate of electrons, which results in the holes in the quantum dot light-emitting layer 130 than the electrons in the quantum dot light-emitting layer 130. By providing the electron transport adjustment layer 140, the number of electrons transported from the first electrode 110 to the quantum dot light-emitting layer 130 is increased. In this way, it may be possible to effectively promote the balance between electrons and holes in the quantum dot light-emitting layer 130, which may effectively improve the light-emitting efficiency and the stability, the service life of the light-emitting device 100.

As can be seen from the above, in embodiments of the present disclosure, the electron transport adjustment layer 140 between the first electrode 110 and the quantum dot light-emitting layer 130 may adjust the number of electrons transmitted from the first electrode 110 to the quantum dot light-emitting layer 130. In this way, it may be possible to effectively promote the balance between electrons and holes in the quantum dot light-emitting layer 130, which may effectively improve the light-emitting efficiency, the stability and the service life of the light-emitting device 100.

In some embodiments, with continued reference to FIGS. 4A-1 and 4A-2, the electron transport adjustment layer 140 includes an electron transport layer 141 and an electron adjustment layer 142.

Here, the electron transport layer 141 is located between the first electrode 110 and the quantum dot light-emitting layer 130, and the electron adjustment layer 142 is located between the electron transport layer 141 and the first electrode 110.

Here, a material of the electron transport layer 141 is at least one material selected from an inorganic nanomaterial, a doped inorganic nanomaterial and an organic material.

For example, the material of the electron transport layer 141 is an inorganic nanomaterial. For example, the electron transport layer 141 may be a zinc oxide-based nanoparticle thin film or a zinc oxide thin film.

In addition, in a case where the electron transport layer 141 is a zinc oxide-based nanoparticle thin film, the material of the electron transport layer 141 may be selected from ion-doped zinc oxide nanoparticles, such as magnesium-doped (Mg-doped) magnesium oxide nanoparticles, indium-doped (In-doped) magnesium oxide nanoparticles, aluminum-doped (Al-doped) magnesium oxide nanoparticles, or gallium-doped (Ga-doped) magnesium oxide nanoparticles.

Here, the electron adjustment layer 142 is configured to adjust the number of electrons transported from the first electrode 110 to the quantum dot light-emitting layer 130.

For example, the electron adjustment layer 142 is provided on a side of the electron transport layer 141 away from the quantum dot light-emitting layer 130. An energy level of the electron transport adjustment layer 140 may be adjusted through a surface charge transfer doping effect.

It will be noted that, the surface charge transfer doping effect is a method of adjusting an energy level of a metal oxide by forming an electron donor or an electron acceptor on a surface of a material.

For example, the electron adjustment layer 142 is formed on a surface of the electron transport layer 141, so that an energy level of a lowest unoccupied molecular orbital (LUMO) of the electron transport layer 141 may be adjusted.

In some examples, the electron adjustment layer 142 is formed on the surface of the electron transport layer 141, so that the energy level of the lowest unoccupied molecular orbital of the electron transport layer 141 is reduced. This increases an energy level difference between the electron transport layer 141 and the quantum dot light-emitting layer 130 and an electron injection barrier, thereby inhibiting an injection of electrons into the quantum dot light-emitting layer 130. That is, the electron adjustment layer 142 may reduce the number of electrons transported from the first electrode 110 to the quantum dot light-emitting layer 130, which effectively promotes the balance between electrons and holes in the quantum dot light-emitting layer 130.

In some other examples, the electron adjustment layer 142 is formed on the surface of the electron transport layer 141, so that the energy level of the lowest unoccupied molecular orbital of the electron transport layer 141 is increased. This reduces the energy level difference between the electron transport layer 141 and the quantum dot light-emitting layer 130 and the electron injection barrier, thereby facilitating the injection of electrons into the quantum dot light-emitting layer 130. That is, the electron adjustment layer 142 may increase the number of electrons transported from the first electrode 110 to the quantum dot light-emitting layer 130, which effectively promotes the balance between electrons and holes in the quantum dot light-emitting layer 130.

As can be seen from the above, in the embodiments of the present disclosure, the electron transport adjustment layer 140 includes the electron transport layer 141 and the electron adjustment layer 142, so that the number of electrons transported from the first electrode 110 to the quantum dot light-emitting layer 130 is adjusted by the electron transport layer 142. In this way, it may be possible to effectively promote the balance between electrons and holes in the quantum dot light-emitting layer 130, thereby effectively improving the light-emitting efficiency, the stability and the service life of the light-emitting device 100.

In some other embodiments of the present disclosure, the light-emitting device 100 includes the first electrode 110, the electron transport adjustment layer 140, the quantum dot light-emitting layer 130 and the second electrode 120 that are arranged in sequence.

Here, the electron transport adjustment layer 140 includes the electron transport layer 141 and the electron adjustment layer 142.

The electron transport layer 141 is located between the first electrode 110 and the quantum dot light-emitting layer 130, and the electron adjustment layer 142 is located between the electron transport layer 141 and the quantum dot light-emitting layer 130.

It is found from researches of the inventor of the present disclosure that, in a case where the electron adjustment layer 142 is closer to the quantum dot light-emitting layer 130 than the electron transport layer 141, since different ions having different ionic radii lead to lattice mismatch, it is prone to cause lattice defects in the quantum dot light-emitting layer 130, and eventually cause fluorescence quenching, thereby reducing the light-emitting efficiency of the light-emitting device 100.

Compared with these embodiments, since the electron adjustment layer 142 in the previous embodiments of the present disclosure is located between the electron transport layer 141 and the first electrode 110, it may be possible to effectively avoid a problem of fluorescence quenching in the quantum dot light-emitting layer 130 due to the proximity of the electron adjustment layer 142 to the quantum dot light-emitting layer 130.

In some embodiments, the electron transport layer 141 and the electron adjustment layer 142 together include at least three elements, and the electron transport layer 141 and the electron adjustment layer 142 include at least one same element.

For example, a material of the electron adjustment layer 142 includes MoOs, and the material of the electron transport layer 141 includes ZnO. For another example, the material of the electron adjustment layer 142 includes $WO_3$, and the material of the electron transport layer 141 includes ZnMgO.

In these embodiments, the electron transport layer 141 and the electron adjustment layer 142 include the at least one same element, so that lattice matching between electron transport layer 141 and the electron adjustment layer 142 is good. This may optimize characteristics of a contact interface between the electron transport layer 141 and the electron adjustment layer 142, thereby improving device characteristics and stability of the light-emitting device 100.

It will be noted that, electrons and holes having different injection rates may be that, an injection rate of electrons is greater than an injection rate of holes, which results in more electrons than holes in the quantum dot light-emitting layer 130; or may be that, the injection rate of holes is greater than the injection rate of electrons, which results in more holes than electrons in the quantum dot light-emitting layer 130.

In some possible embodiments, in a case where there are more electrons than holes in the quantum dot light-emitting layer 130, a work function of the electron adjustment layer 142 is greater than a work function of the electron transport layer 141, and the work function of the electron adjustment layer 142 is greater than a work function of the first electrode 110. The electron adjustment layer 142 is configured to reduce the number of electrons transported from the first electrode 110 to the quantum dot light-emitting layer 130.

For example, as shown in FIG. 4B, the work function of the electron adjustment layer 142 is greater than the work function of the electron transport adjustment layer 141; and since a difference between a vacuum level (Evac) and a Fermi level (Ef) is a work function, a Fermi level of the electron adjustment layer 142 is lower than a Fermi level of the electron transport layer 141 on a basis of a certain vacuum level. In a case where the electron adjustment layer 142 is disposed between the electron transport layer 141 and the first electrode 110, electrons spontaneously transfer from the electron transport layer 141 with a low work function to the electron adjustment layer 142 with a high work function. The Fermi level of the electron transport layer 141 moves toward a valence band (VB) direction after the electron transport layer 141 loses a portion of electrons. That is, an energy level of the electron transport layer 141 becomes deeper. In this case, an energy level difference between the electron transport layer 141 and the quantum dot light-emitting layer 130 becomes larger, and an electron injection barrier is increased. Therefore, the injection of electrons into the quantum dot light-emitting layer 130 is inhibited, the balance between carriers is promoted, an accumulation of excess electrons in the quantum dot light-emitting layer 130 is reduced, and the balance between electrons and holes in the quantum dot light-emitting layer 130 are effectively promoted.

It will be noted that, energy bands of a material are divided into valence bands and conduction bands (CBs), and a Fermi level is a highest energy level filled with electrons and generally located between a valence band and a conduction band.

In the present disclosure, tests are performed on a reference light-emitting device and a test light-emitting

9

device 1. Here, the reference light-emitting device includes a first electrode 110, an electron transport layer 141, a quantum dot light-emitting layer 130 and a second electrode 120 that are arranged in sequence.

The test light-emitting device 1 here is the light-emitting device 100 provided in the above embodiments of the present disclosure, and includes a first electrode 110, an electron transport adjustment layer 140, a quantum dot light-emitting layer 130 and a second electrode 120 that are arranged in sequence. Here, the electron transport adjustment layer 140 includes an electron transport layer 141 and an electron adjustment layer 142, an electron transport layer 141 is located between the first electrode 110 and the quantum dot light-emitting layer 130, and the electron transport layer 142 is located between the electron transport layer 141 and the first electrode 110. A work function of the electron adjustment layer 142 is greater than a work function of the electron transport layer 141, and the work function of the electron adjustment layer 142 is greater than a work function of the first electrode 110.

Here, it will be noted that, for the reference light-emitting device and the test light-emitting device 1, the first electrodes 110 are made of a same material and have a same thickness, the electron transport layers 141 are made of a same material and have a same thickness, the quantum dot light-emitting layers 130 are made of a same material and have a same thickness, and the second electrodes 120 are made of a same material and have a same thickness.

For example, for the reference light-emitting device and the test light-emitting device 1, the first electrodes 110 are each a silver film, and thicknesses of the first electrodes 110 are each 100 nm.

For the reference light-emitting device and the test light-emitting device 1, materials of the electron transport layers 141 are each ZnO, and thicknesses of the electron transport layers 141 are each 50 nm.

For the reference light-emitting device and the test light-emitting device 1, the quantum dot light-emitting layers 130 are made of the same material, and each may be formed as follows: performing coating with an octane solution of same quantum dots at 15 mg/ml on a side of a respective electron transport layer 141 away from a respective first electrode 110, and performing annealing at 120°C, so that the quantum dot light-emitting layers 130 with the same thickness (e.g., a thickness of approximately 30 nm) are obtained.

For the reference light-emitting device and the test light-emitting device 1, materials of the second electrodes 120 are each indium zinc oxide (IZO), and thicknesses of the second electrodes 120 may each be 50 nm.

For the test light-emitting device 1, a material of the electron adjustment layer 142 is MoOs, and a thickness of the electron adjustment layer 142 is 1 nm.

After testing, a schematic diagram of variations of current density versus voltage as shown in FIG. 5 and a schematic diagram of variations of brightness of the light-emitting devices versus voltage as shown in FIG. 6 may be obtained. As can be seen from FIG. 5, a current density of the test light-emitting device 1 is lower than a current density of the reference light-emitting device. As can be seen from FIG. 6, at a same current density, a brightness of the test light-emitting device 1 is higher than a brightness of the reference light-emitting device. As can be concluded from this, in a case where the light-emitting device 100 includes the electron transport adjustment layer 140, the electron transport adjustment layer 140 includes the electron transport layer 141 and the electron adjustment layer 142, the work function of the electron adjustment layer 142 is greater than the work function of the electron transport layer 141, and the work function of the electron transport layer 142 is greater than the work function of the first electrode 110, it may be possible to effectively reduce the number of electrons transported from the first electrode 110 to the quantum dot light-emitting layer 130 and promote the balance between electrons and holes, and the light-emitting efficiency of the light-emitting device 100 may also be effectively improved after the number of electrons injected into the quantum dot light-emitting layer 130 is reduced.

In some embodiments, the work function of the electron adjustment layer 142 is E, and the thickness of the electron adjustment layer 142 is D, where E and D satisfy:

$$1 < \frac{E}{D} < 23.33 \,.$$

For example, a value of may be 1, 1.5, 5, 10, 15 or 20.

For example, the work function of the electron adjustment layer 142 is 5 eV, and the thickness of the electron adjustment layer 142 may be 5 nm. For another example, the work function of the electron adjustment layer 142 is 6 eV, and the thickness of the electron adjustment layer 142 may be 0.3 nm.

Through the arrangement described above, it may be ensured that the electron adjustment layer 142 plays a good adjustment role on the electron transport layer 141, and the injection of electrons into the quantum dot light-emitting layer 130 is inhibited or promoted by increasing or reducing the electron injection barrier. Therefore, the balance between electrons and holes in the quantum dot light-emitting layer 130 is effectively promoted, which may effectively improve the light-emitting efficiency, the stability and the service life of the light-emitting device 100.

In some embodiments, the work function of the electron adjustment layer 142 is in a range of 5 eV to 7 eV, inclusive. For example, the work function of the electron adjustment layer 142 may be 5 eV, 5.5 eV, 6 eV, 6.5 eV or 7 eV.

It will be noted that, the work function or a Fermi level of the first electrode 110 is less than 4.5 eV, and the Fermi level of the electron transport layer 141 is less than 4.5 eV.

Since the work functions or the Fermi levels of the first electrode 110 and the electron transport layer 141 are both less than 4.5 eV, in a case where the work function of the electron adjustment layer 142 between the first electrode 110 and the electron transport layer 141 is in the range of 5 eV to 7 eV, inclusive, electrons spontaneously transfer from the materials with the low work function or the low Fermi level to the material with the high work function. Therefore, in the light-emitting device 100 provided by the present disclosure, when voltages are respectively applied on the first electrode 110 and the second electrode 120, electrons transfer from the first electrode 110 to the electron transport layer 141; and then, since the work function of the electron adjustment layer 142 is greater than the work function or the Fermi level of the material of the electron transport layer 141, electrons spontaneously transfer from the electron transport layer 141 with the low work function to the electron adjustment layer 142 with the high work function. In addition, a difference between the work function of the electron adjustment layer 142 and the work function of the electron transport layer 141 is large, which is conducive to the spontaneous transfer of electrons from the electron transport layer 141 to the electron adjustment layer 142. Therefore, the injection of electrons into the quantum dot light-emitting layer 130 is reduced, the balance between carriers in the light-emitting device 100 is promoted, and the accumulation of excess electrons in quantum dots is reduced, which improves the device efficiency and the service life.

In some embodiments, an energy level of a highest occupied molecular orbital (HOMO) of the electron adjustment layer 142 is in a range of -7 eV to -10 eV, inclusive. For example, the energy level of the highest occupied molecular orbital of the electron adjustment layer 142 may be -7 eV, -8 eV, -9 eV or -10 eV. An energy level of a lowest unoccupied molecular orbital (LUMO) of the electron adjustment layer 142 is in a range of -4.2 eV to -6 eV, inclusive. For example, the energy level of the lowest unoccupied molecular orbital of the electron adjustment layer 142 may be -4.2 eV, -4.6 eV, -5.0 eV, -5.2 eV, -5.4 eV, -5.6 eV or -6 eV.

It will be noted that, according to the frontier orbital theory, there are electron(s) in a molecule that are similar to valence electron(s) in a single atom, and the "valence electron(s)" of the molecule are frontier electron(s). Therefore, during a chemical reaction between molecules, molecule orbitals that act first are frontier orbitals, and electrons that play a key role are frontier electrons. A HOMO of a molecule has a loose binding on electrons therein, and has properties of an electron donor; while a LUMO has a strong affinity for electrons, and has properties of an electron acceptor.

For example, with reference to FIGS. 7 and 8, FIG. 7 is a diagram showing an energy level structure of the reference light-emitting device described above, and FIG. 8 is a diagram showing an energy level structure of the light-emitting device 100 in these embodiments.

As can be seen in conjunction with FIGS. 7 and 8, after the electron adjustment layer 142 is formed on the surface of the electron transport layer 141, the energy level of the lowest unoccupied molecular orbital of the electron transport layer 141 is reduced, and the energy level difference between the electron transport layer 141 and the quantum dot light-emitting layer 130 is increased. Therefore, the electron injection barrier is increased, and the injection of electrons into the quantum dot light-emitting layer 130 is inhibited. The energy level of the LUMO of the electron adjustment layer 142 is deeper than the energy level of the LUMO of the electron transport layer 141. An energy level of a LUMO is comparable in magnitude to an electron affinity of a molecule. The lower the energy level of the LUMO is, the easier it is for the electron adjustment layer 142 to obtain electrons. Therefore, it is easy for electrons to transfer from the electron transport layer 141 to the electron adjustment layer 142, which may effectively improve a quantum dot charging phenomenon caused by excessive electrons injected from the electron transport layer 141 into the quantum dot light-emitting layer 130, and promote the balance between electrons and holes.

In some embodiments, the material of the electron adjustment layer 142 includes an oxide of a metal of a fifth sub-group, or an oxide of a metal of a sixth sub-group.

For example, the material of the electron adjustment layer 142 includes at least one metal oxide of a molybdenum oxide, a tungsten oxide or a chromium oxide.

In a case where the material of the electron adjustment layer 142 includes an oxide of a metal of a fifth sub-group, or an oxide of a metal of a sixth sub-group, after the electron adjustment layer 142 is formed on the surface of the electron transport layer 141, the energy level of the lowest unoccupied molecular orbital of the electron transport layer 141 is reduced, and the electron injection barrier is increased, thereby inhibiting the injection of electrons into the quantum dot light-emitting layer 130. Moreover, in the case where the material of the electron adjustment layer 142 includes an oxide of a metal of a fifth sub-group, the energy level of the LUMO of the electron adjustment layer 142 is deeper than the energy level of the LUMO of the electron transport layer 141. An energy of a LUMO is comparable in magnitude to an electron affinity of a molecule. The lower the energy level of the LUMO, the easier it is for the substance to obtain electrons. Therefore, it is easy for electrons to transfer from the electron transport layer 141 to the electron adjustment layer 142, which may effectively improve a quantum dot charging phenomenon caused by excessive electrons injected from the electron transport layer 141 into the quantum dot light-emitting layer 130, and promote the balance between electrons and holes.

In some embodiments, the material of the electron adjustment layer 142 includes at least one of $MoO_3$, $WO_3$,

$V_2O_5$ or $CrO_3$, and the material of the electron transport layer 141 includes at least one of ZnO, ZnS, ZnSe, ZnMgO, NiO, CdS, CdSe or CdO.

Materials such as $MoO_3$, $WO_3$, $V_2O_5$ and $CrO_3$ each have a high work function. In addition, materials such as ZnO, ZnS, ZnSe, ZnMgO, NiO, CdS, CdSe and CdO are compounds of transition metals, and are generally n-type semiconductors, so that the energy level of the lowest unoccupied molecular orbital of the electron transport layer 141 including the material(s) is easily adjusted by the electron adjustment layer 142 with a higher work function. Under an action of the electron adjustment layer 142, the energy level of the lowest unoccupied molecular orbital of the electron transport layer 141 is lowered. This increases the energy level difference between the electron transport layer 141 and the quantum dot light-emitting layer 130, and increases the electron injection barrier, thereby inhibiting the injection of electrons into the quantum dot light-emitting layer 130.

In some embodiments, the energy level of the lowest unoccupied molecular orbital of the electron transport layer 141 is less than an energy level of a lowest unoccupied molecular orbital of the electron transport adjustment layer 140.

In the present disclosure, tests are performed on the energy level of the lowest unoccupied molecular orbital of the electron transport adjustment layer 140 and the energy level of the lowest unoccupied molecular orbital of the electron transport layer 141.

For example, the tests are conducted by taking an example where the material of the electron transport layer 141 includes ZnO and the material of the electron adjustment layer 142 includes MoOs.

First, coating is performed with a solution of ZnO at 30 mg/ml on cleaned ITO conductive glass, and annealing is performed at 120°C for 10 min, so that electron transport layers 141 with a thickness of approximately 50 nm are obtained; and then, a $MoO_3$ layer with a thickness of 1 nm and a MoOs layer with a thickness of 3 nm are formed on the respective electron transport layers 141 by evaporation. Variations in the energy levels thereof are tested by using ultraviolet photoelectron spectroscopy (UPS).

Test results are as shown in Table 1.

Table 1

| NO. | Electron transport layer | Electron adjustment layer | Eontset / eV | Ecutoff / eV | HOMO / eV |
|---|---|---|---|---|---|
| 1 | | None | 3.68 | 17.65 | -7.25 |
| 2 | ZnO | $MoO_3$, 1 nm | 3.64 | 17.53 | -7.33 |
| 3 | | $MoO_3$, 3 nm | 3.55 | 17.20 | -7.57 |

As can be seen from Table 1, in a case where the light-emitting device does not include an electron adjustment layer, it is measured that Eonset at a position of an initial binding energy of the electron transport layer 141 is 3.68 eV, and Ecutoff at a position of an energy cutoff edge of the electron transport layer 141 is 17.65 eV. Here, as shown in FIGS. 9A and 9B, FIGS. 9A and 9B are each a schematic diagram showing a variation of number of photoelectrons generated by the electron transport layer 141 versus binding energy of the electron transport layer 141 in the case where the light-emitting device does not include an electron adjustment layer. For each of FIG. 9A and FIG. 9B, an abscissa represents an binding energy of the electron transport layer 141, and an ordinate represents the number of photoelectrons generated by the electron transport layer 141 under an excitation of ultraviolet (UV) incident light. Eontoff is an energy corresponding to a position of an initial binding energy of the electron transport layer 141, i.e., a magnitude of a binding energy at an intersection of a straight line and the abscissa in the figure as shown in FIG. 9B. Ecutoff is an energy corresponding to the position of the energy cutoff edge of the electron transport layer 141, i.e., a magnitude of a binding energy at an intersection of a straight line and the abscissa in the figure as shown in FIG. 9A.

Here, a formula for the energy level of the HOMO of the electron transport layer 141 is:

$$HOMO = -(21.22 - (Ecutoff - Eonset)).$$

Therefore, in the case where the light-emitting device does not include an electron adjustment layer, it is measured that the energy level of the highest occupied molecular orbital of the electron transport layer 141 is -7.25 eV.

As can be seen from Table 1, in a case where the light-emitting device includes the electron adjustment layer 142, the material of the electron adjustment layer 142 is $MoO_3$, and the thickness of the electron adjustment layer 142 is 1 nm, it is measured that Eonset of the electron transport adjustment layer 140 is 3.64 eV, and Ecutoff of the electron transport adjustment layer 140 is 17.53 eV. Here, as shown in FIGS. 10A and 10B, FIGS. 10A and 10B are each a schematic diagram showing a variation of binding energy of the electron transport adjustment layer 140 versus number of photoelectrons generated by the electron transport adjustment layer 140 in the case where the light-emitting device includes the electron adjustment layer 142, the material of the electron adjustment layer 142 is $MoO_3$, and the thickness of the electron adjustment layer 142 is 1 nm. For each of FIGS. 10A and 10B, an abscissa is the binding energy of the electron transport adjustment layer 140, and an ordinate is the number of photoelectrons generated by the electron transport adjustment layer 140 under an excitation of ultraviolet (UV) incident light. Eontoff is an energy corresponding to a position of an initial binding energy of the electron transport adjustment layer 140, i.e., a magnitude of a binding energy at an intersection of a straight line and the abscissa in the figure as shown in FIG. 10B. Ecutoff is an energy corresponding to a position of an energy cutoff edge of the electron transport adjustment layer 140, i.e., a magnitude of a binding energy at an intersection of a straight line and the abscissa in the figure as shown in FIG. 10A.

Here, a formula for the energy level of the HOMO of the electron transport adjustment layer 140 is:

$$HOMO = -(21.22 - (Ecutoff - Eonset)).$$

As can be calculated according to the formula for the energy level of the HOMO of the electron transport adjustment layer 140, in the case where the light-emitting device includes the electron adjustment layer 142, the material of the electron adjustment layer 142 is $MoO_3$, and the thickness of the electron adjustment layer 142 is 1 nm, the energy level of the HOMO of the electron transport adjustment layer 140 is -7.33 eV.

As can be seen from Table 1, in a case where the light-emitting device includes the electron adjustment layer 142, the material of the electron adjustment layer 142 is $MoO_3$, and the thickness of the electron adjustment layer 142 is 3 nm, it is measured that Eonset of the electron transport adjustment layer 140 is 3.55 eV, and Ecutoff of the electron transport adjustment layer 140 is 17.20 eV. Here, as shown in FIGS. 11A and 11B, FIGS. 11A and 11B are each a schematic diagram showing a variation of binding energy of the electron transport adjustment layer 140 versus number of photoelectrons generated by the electron transport adjustment layer 140 in the case where the light-emitting device includes the electron adjustment layer 142, the material of the electron adjustment layer 142 is $MoO_3$, and the thickness of the electron adjustment layer 142 is 3 nm. For each of FIGS. 11A and 11B, an abscissa is the binding energy of the electron transport adjustment layer 140, and an ordinate is the number of photoelectrons generated by the electron transport adjustment layer 140 under an excitation of ultraviolet (UV) incident light. Eontoff is an energy corresponding to a position of an initial binding energy of the electron transport adjustment layer 140, i.e., a magnitude of a binding energy at an intersection of a straight line and the abscissa in the figure as shown in FIG. 11B. Ecutoff is an energy corresponding to a position of an energy cutoff edge of the electron transport adjustment layer 140, i.e., a magnitude of a binding energy at an intersection of a straight line and the abscissa in the figure as shown in FIG. 11A.

As can be calculated according to the formula for the energy level of the HOMO of the electron transport adjustment layer 140, in the case where the light-emitting device includes the electron adjustment layer 142, the material of the electron adjustment layer 142 is MoOs, and the thickness of the electron adjustment layer 142 is 3 nm, the energy level of the HOMO of the electron transport adjustment layer 140 is -7.57 eV.

It is clear that, after the electron transmission layer 142 is formed on the surface of the electron transport layer 141, i.e., in a case where the electron transport adjustment layer 140 includes the electron transport layer 141 and the electron adjustment layer 142, the energy of the highest occupied molecular orbital of the electron transport adjustment layer 140 decreases, the energy level difference between the electron transport adjustment layer 140 and the quantum dot light-emitting layer 130 increases, and the electron injection barrier increases.

In the present disclosure, in order to test the energy level of the LUMO of the electron transport adjustment layer 140, tests are performed on the electron transport adjustment layer 140 by using the ultraviolet-visible (UV-vis) absorption spectrum.

For example, first, coating is performed with a solution of ZnO at 30 mg/ml on blank glass, and annealing is performed at 120°C for 10 min, so that electron transport layers 141 with a thickness of approximately 50 nm are obtained; and then, a $MoO_3$ layer with a thickness of 1 nm and a $MoO_3$ layer with a thickness of 3 nm are respectively formed by evaporation, and tests for the ultraviolet-visible (UV-vis) absorption spectrum are performed on the film layers.

Test results are as shown in FIGS. 12A to 12D. FIGS. 12A to 12D are each a diagram showing absorption intensity of film layer(s) for light of different wavelengths, where an abscissa is a wavelength of the light, and an ordinate is an absorption intensity of a film layer for the light. Here, FIG. 12B shows a ultraviolet-visible absorption spectrum of the electron transport layer 141 at different wavelengths in the case where the light-emitting device does not include an electron adjustment layer; FIG. 12C shows a ultraviolet-visible absorption spectrum of the electron transport layer 141 at different wavelengths in the case where the light-emitting device 100 includes the electron adjustment layer 142, the electron adjustment layer 142 is the $MoO_3$ layer with the thickness of 1 nm; FIG. 12D shows a ultraviolet-visible absorption spectrum of the electron transport layer 141 at different wavelengths in the case where the light-emitting device 100 includes the electron adjustment layer 142, the electron adjustment layer 142 is the $MoO_3$ layer with the thickness of 3 nm; and FIG. 12A shows ultraviolet-visible absorption spectrums corresponding to the above three cases.

As can be seen from FIGS. 12A to 12D, there is almost no difference between the absorption spectra of the film layers.

A formula for calculating a band gap Egap of a film layer is:

$$Egap = \frac{1240}{\lambda g},$$

where λg is a band edge wavelength of the film layer, i.e., a wavelength for an intersection of a cutting line and the abscissa in each of FIGS. 12C to 12D.

According to the formula for calculating the band gap Egap of the film layer, in the case where the light-emitting device does not include an electron adjustment layer, a band gap Egap of the electron transport layer 141 is 3.53 eV; in the case where the light-emitting device includes the electron adjustment layer 142, the material of the electron adjustment layer 142 is MoO$_3$, and the thickness of the electron adjustment layer 142 is 1 nm, a band gap Egap of the electron transport adjustment layer 140 is 3.54 eV; and in the case where the light-emitting device includes the electron adjustment layer 142, the material of the electron adjustment layer 142 is MoO$_3$, and the thickness of the electron adjustment layer 142 is 3 nm, a band gap Egap of the electron transport adjustment layer 140 is 3.53 eV.

A formula for the energy level of the HOMO of an electron transport adjustment layer 140 is:

$$ELUMO = EHOMO + Egap,$$

where ELUMO is the energy level of the lowest unoccupied molecular orbital of the electron transport adjustment layer 140, EHOMO is the energy level of the highest occupied molecular orbital of the electron transport adjustment layer 140, and Egap is the band gap of the electron transport adjustment layer 140. According to an ultraviolet-visible absorption spectrum of a film layer, a band gap Egap of the film layer can be calculated; and then, according to a measured energy level of the HOMO of the electron transport adjustment layer 140, the energy level of the LUMO of the electron transport adjustment layer 140 can be obtained.

Calculation results are as shown in Table 2.

Table 2

| NO. | Electron transport layer | Electron adjustment layer | HOMO / eV | Band gap / eV | LUMO / eV |
|---|---|---|---|---|---|
| 1 | | None | -7.25 | 3.53 | -3.71 |
| 2 | ZnO | MoO$_3$, 1 nm | -7.33 | 3.54 | -3.79 |
| 3 | | MoO$_3$, 3 nm | -7.57 | 3.53 | -4.04 |

As can be seen from Table 2, by comparing an energy level of a LUMO of the electron transport adjustment layer 140 in the case where the light-emitting device includes the electron transport layer 141 and the electron adjustment layer 142 with an energy level of a LUMO of the electron transport layer 141 in the case where the light-emitting device only includes the electron transport layer 141 and does not include the electron adjustment layer 142, the energy level of the LUMO of the electron transport adjustment layer 140 is decreased. This increases the electron injection barrier, thereby reducing the injection of electrons into the quantum dot light-emitting layer 130.

In the present disclosure, X-ray photoelectron spectroscopy (XPS) is used to test changes in binding energy peak position of the film layers corresponding to the above three cases.

For example, with reference to FIGS. 13A and 13B, FIG. 13A is a schematic diagram showing changes in number of photoelectrons generated by the electron transport layers 141 with binding energy of the electron transport layers 141 in the above three cases; and FIG. 13B is a partial enlarged view of a region A in FIG. 13A.

In the case where the light-emitting device only includes the electron transport layer 141 and does not include an electron adjustment layer, a binding energy of a peak position of a 2p orbital of Zn in the electron transport layer 141 is 1021.4 eV. In a case where the light-emitting device includes the electron transport layer 141 and the electron adjustment layer 142, and the electron adjustment layer 142 is the MoO$_3$ layer with the thickness of 1 nm, a binding energy of a peak position of a 2p orbital of Zn in the electron transport adjustment layer 140 is 1021.5 eV. In the case where the light-emitting device includes the electron transport layer 141 and the electron adjustment layer 142, and the electron adjustment layer 142 is the MoO$_3$ layer with the thickness of 3 nm, a binding energy of a peak position of a 2p orbital of Zn in the electron transport adjustment layer 140 is 1021.8 eV. It is clear that, after the electron adjustment layer 142 is formed on the surface of the electron transport layer 141, the binding energy of the peak position of the 2p orbital of Zn in the electron transport layer 141 changes. That is, by forming the electron adjustment layer 142 on the surface of the electron transport adjustment layer 140, an electronic structure of the electron transport layer 141 is changed, and the electron injection barrier is changed. Thus, the number of electrons transport from the first electrode 110 to the quantum dot light-emitting layer 130 is adjusted, which balances the injection of electrons and the injection of holes in the light-emitting device 100.

In some embodiments, a roughness of a surface of the electron adjustment layer 142 away from the electron transport layer 141 is less than a roughness of a surface of the electron transport layer 141 away from the electron adjustment layer 142.

For example, coating is performed with a solution of ZnO at 30 mg/ml on blank glass, and annealing is performed at 120°C for 10 min to obtain an electron transport layer 141 with a thickness of approximately 50 nm; and an atomic force microscope (AFM) is used to observe a surface morphology of the electron transport layer 141.

For example, first, coating is performed with a solution of ZnO at 30 mg/ml on a blank glass, and annealing is performed at 120°C for 10 min to obtain an electron transport layer 141 with a thickness of approximately 50 nm; and then, evaporation is performed to form a $MoO_3$ layer, and an atomic force microscope (AFM) is used to observe a surface morphology of the $ZnO/MoO_3$ laminated layer (i.e., an electron transport adjustment layer 140).

For example, as shown in FIGS. 14A and 14B, FIG. 14A shows a film layer electron micrograph of the electron transport layer 141 in the case where the light-emitting device does not include an electron adjustment layer, and FIG. 14B shows a film layer electron micrograph of the $ZnO/MoO_3$ laminated layer (i.e., the electron transport adjustment layer 140) in the case where the light-emitting device includes the electron adjustment layer 142.

As can be seen through testing, in the case where the light-emitting device does not include an electron adjustment layer, a roughness of a surface of an electron transport layer 141 is 5.5 nm; and in a case where a light-emitting device includes an electron adjustment layer 142, a roughness of a surface of the $ZnO/MoO_3$ laminated layer (i.e., the electron transport adjustment layer 140) is 5.1 nm.

It is clear that, in the case where a light-emitting device 100 includes the electron transport layer 141 and the electron adjustment layer 142, the roughness of the electron transport adjustment layer 140 is significantly reduced, which may improve a morphology and light-emitting evenness of the light-emitting device 100.

In some other possible embodiments, in a case where there are more holes than electrons in the quantum dot light-emitting layer 130, the work function of the electron adjustment layer 142 is less than the work function of the electron transport layer 141, and the work function of the electron adjustment layer 142 is less than the work function of the first electrode 110. The electron adjustment layer 142 is configured to increase the number of electrons transported from the first electrode 110 to the quantum dot light-emitting layer 130.

Since the work function of the electron adjustment layer 142 is less than the work functions of the electron transport layer 141 and the first electrode 110, in a case where the electron adjustment layer 142 is provided between the electron transport layer 141 and the first electrode 110, electrons spontaneously transfer from the electron adjustment layer 142 with a low Fermi level to the electron transport layer 141 with a high work function. This may increase the number of electrons transported from the first electrode 110 to the quantum dot light-emitting layer 130, promote the injection of electrons in the light-emitting device 100, balance the injection of electrons and the injection of holes in the light-emitting device 100, and avoid the accumulation of carriers, which is conducive to improving the light-emitting efficiency of the light-emitting device.

In the embodiments, the material of the electron adjustment layer 142 includes $Cs_2O_3$.

$Cs_2O_3$ is a good cathode modification material with a low work function, and may be used as an electron donating material. In a case where the material of the electron adjustment layer 142 includes $Cs_2O_3$, it is conducive to the spontaneous transfer of electrons from the electron adjustment layer 142 to the electron transport layer 141. This increases the number of electrons transported from the first electrode 110 to the quantum dot light-emitting layer 130, promote the injection of electrons in the light-emitting device 100, balance the injection of electrons and the injection of holes in the light-emitting device 100, and avoid the accumulation of carriers, which is conducive to improving the light-emitting efficiency of the light-emitting device.

In some embodiments, the thickness of the electron adjustment layer 142 is in a range of 0.3 nm to 5 nm, inclusive. For example, the thickness of the electron adjustment layer may be 0.3 nm, 0.4 nm, 0.5 nm, 0.6 nm, 0.7 nm, 0.8 nm, 0.9 nm, 1 nm, 1.1 nm, 1.2 nm, 1.3 nm, 1.4 nm, 1.5 nm, 1.6 nm, 1.7 nm, 1.8 nm, 1.9 nm, 2 nm, 3 nm, 4 nm or 5 nm, which is not limited in embodiments of the present disclosure.

In the present disclosure, the reference light-emitting device, and test light-emitting devices 2 to 5 are tested. The reference light-emitting device includes a first electrode 110, an electron transport layer 141, a quantum dot light-emitting layer 130 and a second electrode 120 that are arranged in sequence.

The test light-emitting device 2 is the light-emitting device 100 provided in some embodiments of the present disclosure, and includes a first electrode 110, an electron adjustment layer 142, an electron transport layer 141 and a quantum dot light-emitting layer 130 and a second electrode 120 that are arranged in sequence. Here, a material of the electron adjustment layer 142 is $MoO_3$ with a thickness of 1 nm.

The test light-emitting device 3 described here is the light-emitting device 100 provided in some other embodiments of the present disclosure, and includes a first electrode 110, an electron adjustment layer 142, an electron transport layer 141 and a quantum dot light-emitting layer 130 and a second electrode 120 that are arranged in sequence. Here, a material of the electron adjustment layer 142 is MoOs with a thickness of 2 nm.

The test light-emitting device 4 described here is the light-emitting device 100 provided in yet some other embodiments of the present disclosure, and includes a first electrode 110, an electron adjustment layer 142, an electron transport layer 141, a quantum dot light-emitting layer 130 and a second electrode 120 that are arranged in sequence. Here, a material of the electron adjustment layer 142 is $MoO_3$ with a thickness of 3 nm.

The test light-emitting device 5 is the light-emitting device 100 provided in yet some other embodiments of the present disclosure, and includes a first electrode 110, an electron adjustment layer 142, an electron transport layer 141, a quantum dot light-emitting layer 130 and a second electrode 120 that are arranged in sequence. Here, a material of the electron adjustment layer 142 is $MoO_3$ with a thickness of 7 nm. Here, it will be noted that, for the reference light-emitting device and the test light-emitting devices 2 to 5, the first electrodes 110 are made of a same material and have a same thickness, the electron transport layers 141 are made of a same material and have a same thickness, the quantum dot light-emitting layers 130 are made of a same material and have a same thickness, and the second electrodes 120 are made of a same material and have a same thickness.

For example, for the reference light-emitting device and the test light-emitting devices 2 to 5, the first electrodes 110 are each a silver film, and thicknesses of the first electrodes 110 are each 100 nm.

For example, for the reference light-emitting device and the test light-emitting devices 2 to 5, materials of the electron transport layers 141 are each ZnO, and thicknesses of the electron transport layers 141 are each 50 nm.

For example, for the reference light-emitting device and the test light-emitting devices 2 to 5, the quantum dot light-emitting layers 130 are made of the same material, and each may be formed as follows: performing coating with an octane solution of same quantum dots at 15 mg/ml on a side of a respective electron transport 141 away from a respective first electrode 110, and performing annealing at 120°C, so that the quantum dot light-emitting layers 130 with the same thickness (e.g., a thickness of approximately 30 nm) are obtained.

For the reference light-emitting device and the test light-emitting devices 2 to 5, materials of the second electrodes 120 are each indium zinc oxide (IZO), and thicknesses of the second electrodes 120 may each be 50 nm. After testing, a schematic diagram showing variations of current efficiency versus voltage as shown in FIG. 15 can be obtained.

As can be seen from FIG. 15, current efficiencies of the test light-emitting devices 2 to 4 are significantly higher than a current efficiency of the reference light-emitting device. The higher a current efficiency is, the higher a light-emitting efficiency of a light-emitting device is. Therefore, light-emitting efficiencies of the test light-emitting devices 2 to 4 are significantly higher than a light-emitting efficiency of the reference light-emitting device. However, a current efficiency of the test light-emitting device 5 is significantly lower than the current efficiencies of the reference light-emitting devices 2 to 4. As can be seen from this, by providing an electronic adjustment layer 142 with a thickness ranging from 0.3 nm to 5 nm, the light-emitting efficiency of the light-emitting device 100 may be effectively improved, and an impact of an excessive thickness of the electron adjustment layer 142 on the light-emitting efficiency of the light-emitting device.

In some other embodiments of the present disclosure, with reference to FIG. 16, the electron transport adjustment layer 140 includes a dopant material 1402 and a host material 1401. The dopant material 1402 is configured to adjust the number of electrons transported from the first electrode 110 to the quantum dot light-emitting layer 130.

Here, the electron transport adjustment layer 140 may be formed by performing doping through an ion implantation method or a diffusion process.

In some examples, after the electron transport adjustment layer 140 is doped with the dopant material 1402, the energy level of the lowest unoccupied molecular orbital of the electron transport adjustment layer 140 is less than an energy level of an initial lowest unoccupied molecular orbital of the electron transport adjustment layer 140. Here, the energy level of the initial lowest unoccupied molecular orbital of the electron transport adjustment layer 140 is an energy level of a lowest unoccupied molecular orbital of the electron transport adjustment layer 140 in a case where the electron transport adjustment layer 140 is undoped. In this way, the electron injection barrier is increased, thereby inhibiting the injection of electrons into the quantum dot light-emitting layer 130 and effectively promoting the balance between electrons and holes in the quantum dot light-emitting layer 130. This may effectively improve the light-emitting efficiency, the stability and the service life of the light-emitting device 100.

In some examples, after the electron transport adjustment layer 140 is doped with the dopant material 1402, the energy level of the lowest unoccupied molecular orbital of the electron transport adjustment layer 140 is greater than the energy level of the initial lowest unoccupied molecular orbital of the electron transport adjustment layer 140. In this way, the electron injection barrier is decreased, thereby promoting the injection of electrons into the quantum dot light-emitting layer 130 and effectively promoting the balance between electrons and holes in the quantum dot light-emitting layer 130. This may effectively improve the light-emitting efficiency, the stability and the service life of the light-emitting device 100.

As can be seen from the above, in the embodiments of the present disclosure, the electron transport adjustment layer 140 includes the dopant material 1402 and the host material 1401, and the dopant material 1402 is used for adjusting the number of electrons transported from the first electrode 110 to the quantum dot light-emitting layer 130. In this way, it may be possible to effectively promote the balance between electrons and holes in the light-emitting device 100, and improve the light-emitting efficiency, the stability and the service life of the light-emitting device 100.

In some embodiments, the electron transport adjustment layer 140 includes at least three elements, and the dopant material 1402 and the host material 1401 include at least one same element.

For example, the dopant material 1402 includes MoOs, and the host material 1401 includes ZnO. For another example, the dopant material 1402 includes $WO_3$, and the host material 1401 includes ZnMgO.

In this way, the dopant material 1402 can adjust the energy level of the lowest unoccupied molecular orbital of the host material 1401, adjust the number of electrons transported from the first electrode 110 to the quantum dot light-emitting layer 130, and effectively promote the balance between electrons and holes in the light-emitting device 100.

In some embodiments, a work function of the dopant material 1402 is greater than a work function of the host material 1401, and the work function of the dopant material 1402 is greater than the work function of the first electrode 110. The dopant material 1402 is configured to reduce the number of electrons transported from the first electrode 110 to the quantum dot light-emitting layer 130.

Since the work function of the dopant material 1402 is greater than the work function of the host material 1401, the energy level of the lowest unoccupied molecular orbital of the electron transport adjustment layer 140 after the electron transport adjustment layer 140 is doped with the dopant material 1402 is less than the energy level of the initial lowest unoccupied molecular orbital of the electron transport adjustment layer 140. Therefore, the electron injection barrier is increased, thereby inhibiting the injection of electrons into the quantum dot light-emitting layer 130.

In some embodiments, the dopant material 1402 includes a P-type dopant material.

It will be noted that, the P-type dopant material refers to a material that can accept electrons during doping. By doping the host material 1401 with a P-type dopant material which is likely to accept electrons, the number of electrons transported from the first electrode 110 to the quantum dot light-emitting layer 130 may be reduced, and the injection of electrons into the light-emitting device 100 is inhibited, which balances the injection of electrons and the injection of holes in the light-emitting device 100.

In some embodiments, the P-type dopant material includes at least one of $MoO_3$, $WO_3$, $V_2O_5$ or $CrO_3$.

$MoO_3$, $WO_3$, $V_2O_5$ and $CrO_3$ all have high work functions and are likely to accept electrons. By doping the host material 1401 with at least one of $MoO_3$, $WO_3$, $V_2O_5$ or $CrO_3$, the number of electrons transported from the first electrode 110 to the quantum dot light-emitting layer 130 may be reduced, the injection of electrons into the light-emitting device 100 is inhibited, which balances the injection of electrons and the injection of holes in the light-emitting device 100.

In some embodiments, with reference to FIGS. 4A-1 and 4A-2, the light-emitting device 100 further includes a hole transport layer (HTL) 150 and a hole injection layer (HIL) 160. Here, the hole transport layer 150 is located between the second electrode 120 and the quantum dot light-emitting layer 130, and the hole injection layer 160 is located between the second electrode 120 and the hole transport layer 150.

Here, a material of the hole injection layer 160 includes poly(3,4-ethylenedioxythiophene):polystyrenesulfonate (PEDOTPSS) 4083. In addition to this, the material of the hole injection layer 160 may alternatively include molybdenum oxide ($MoO_3$), tungsten trioxide ($WO_3$), vanadium pentoxide ($V_2O_5$) or copper thiocyanate (CuSCN).

A material of the hole transport layer 150 may be 1,1-bis[4-[N,N'-bis(p-tolyl)amino]phenyl]cyclohexane (TAPC), 4,4',4'' - Tris(carbazol-9-yl)triphenylamine (TCTA) or N,N'-(1-naphthyl)-N,N'-diphenyl-4,4'-biphenyldiamine (NPB). In addition to this, the material of the hole transport layer 150 may alternatively include polyvinyl carbazole (PVK).

For example, with reference to FIGS. 7 and 8, holes from the second electrode 120 pass through the hole injection layer 160 and the hole transport layer 150 in sequence to enter the quantum dot light-emitting layer 130, which reduces a height of a potential barrier needs to be overcome during carrier transition. In this way, by providing the hole injection layer 160 and the hole transport layer 150, a hole transport efficiency may be improved, thereby improving the light-emitting efficiency of the light-emitting device 100.

A method for manufacturing the light-emitting device provided by the above embodiments may vary, which may be determined depending on actual needs. The method for manufacturing the light-emitting device is schematically described below. It will be understood that, the method for manufacturing the light-emitting device is not limited to the description below.

Some embodiments of the present disclosure provide a method for manufacturing a light-emitting device. The method is used for manufacturing the light-emitting device 100 provided in some embodiments above.

FIG. 17 is a flowchart of the method for manufacturing the light-emitting device in accordance with some embodiments. The method includes steps S1a to S3a.

In a step S1a, an electron transport adjustment layer 140 is formed on a side of the first electrode 110.

Here, the first electrode 110 may be an aluminum film or a silver film. The aluminum film or the silver film may be formed by an evaporation process.

In addition, a material of the first electrode 110 may be indium zinc oxide (IZO). In this case, the first electrode 110 may be formed through a sputtering process.

For example, a thickness of the first electrode 110 is in a range from 90 nm to 110nm, inclusive. For example, the thickness of the first electrode 110 is 100 nm.

For example, the electron transport adjustment layer 140 is configured to adjust a number of electrons transported from the first electrode 110 to the quantum dot light-emitting layer 130.

In a step S2a, a quantum dot light-emitting layer 130 is formed on a side of the electron transport adjustment layer 140 away from the first electrode 110.

For example, a thickness of the quantum dot light-emitting layer 130 is in a range of 20 nm to 40 nm, inclusive. For example, the thickness of the quantum dot light-emitting layer 130 is 50 nm.

For example, the quantum dot light-emitting layer 130 may be formed by using a spin coating process or other processes.

For example, a specific step for forming the quantum dot light-emitting layer 130 on the side of the electron transport adjustment layer 140 away from the first electrode 110 may include: performing coating with an octane solution of quantum dots at 15 mg/ml on the side of the electron transport adjustment layer 140 away from the first electrode 110, and performing annealing at 120°C for 10 min to obtain the quantum dot light-emitting layer 130 with a thickness of approximately 30 nm.

In a step S3a, a second electrode 120 is formed on a side of the quantum dot light-emitting layer 130 away from the electron transport adjustment layer 140.

Here, the second electrode 120 may be an aluminum film or a silver film, and the aluminum film or silver film may be formed by an evaporation process.

In addition, a material of the second electrode 120 may be indium zinc oxide (IZO). In this case, the second electrode 120 may be formed through a sputtering process.

After the step S3a, the light-emitting device 100 may be encapsulated. For example, the light-emitting device 100 may be encapsulated by using ultraviolet curing adhesive.

The method for manufacturing a light-emitting device is used for manufacturing the light-emitting device 100 provided in some of the above embodiments. Beneficial effects that the method may achieve are same as the beneficial effects that the light-emitting device 100 provided in some of the above embodiments achieves, which will not be repeated here.

In some embodiments, the step that the electron transport adjustment layer 140 is formed on the side of the first electrode 110 includes steps S11a to S12a.

In a step S11a, an electrode adjustment layer 142 is formed on the side of the first electrode 110 by evaporation.

Here, for a material and a thickness of the electron adjustment layer 142, reference may be made to the description in some of the above embodiments, which will not be repeated here.

By forming the electron adjustment layer 142 by evaporation, the thickness of the electron adjustment layer 142 may be effectively controlled, so that an impact of an excessive thickness of the electron adjustment layer 142 on current efficiency of the light-emitting device is avoided.

In a step S12a, an electron transport layer 141 is formed on a side of the electron adjustment layer 142 away from the first electrode 110.

For example, the thickness of the electron transport layer 141 is in a range of 40 nm to 60 nm, inclusive. For example, the thickness of the electron transport layer 141 is 50 $\mu$m.

For example, the electron transport layer 141 may be formed by using a sol-gel method, a nanoparticle spin-coating method or a sputtering process.

For example, a specific step for forming the electron transport layer 141 on the side of the electron adjustment layer 142 away from the first electrode 110 may include: performing coating with a solution of ZnO at 30 mg/ml on the side of the electron adjustment layer 142 away from the first electrode 110, and performing annealing at 120°C for 10 min to obtain the electron transport layer 141 with a thickness of approximately 50 nm.

In these embodiments, the electron transport adjustment layer 140 includes the electron transport layer 141 and the electron adjustment layer 142. The number of electrons transported from the first electrode 110 to the quantum dot light-emitting layer 130 is adjusted by the electron adjustment layer 142. In this way, it may be possible to effectively promote the balance between electrons and holes in the quantum dot light-emitting layer 130, effectively improve the light-emitting efficiency, the stability and the service life of the light-emitting device 100.

In some other embodiments, the step that the electron transport adjustment layer 140 is formed on the side of the first electrode 110 includes: forming the electron transport adjustment layer 140 on the side of the first electrode 110 by a solution process.

Here, the electron transport adjustment layer 140 includes a dopant material 1402 and a host material 1401. The dopant material 1402 is configured to adjust the number of electrons transported from the first electrode 110 to the quantum dot light-emitting layer 130.

Here, the electron transport adjustment layer 140 may be formed by performing doping through an ion implantation method or a diffusion method.

For example, a specific step for forming the electron transport adjustment layer 140 on the side of the first electrode 110 by the solution process may include: adding molybdenum acetate (Mo (CH$_3$COO)$_2$·2H$_2$O) to a solution of zinc acetate (Zn(CH$_3$COO)$_2$·2H$_2$O) as a precursor solution using for preparing ZnO, adding an appropriate amount of a potassium hydroxide solution to the precursor solution, stirring at 60°C, and finally adding ethanolamine as a stabilizer, so that molybdenum doped ZnO nanoparticles may be obtained.

For example, the electron transport adjustment layer 140 includes the dopant material 1402 doped therein, and the dopant material 1402 is used for adjusting the number of electrons transported from the first electrode 110 to the quantum dot light-emitting layer 130. In this way, it may be possible to effectively promote the balance between electrons and holes in the light-emitting device 100, improve the light-emitting efficiency, the stability and the service life of the light-emitting device 100.

Some embodiments of the present disclosure provide another method for manufacturing a light-emitting device. The method is used for manufacturing the light-emitting device 100 provided in some of the above embodiments.

FIG. 18 is a flowchart of the method for manufacturing the light-emitting device in accordance with some embodiments. The method includes steps S1b to S3b.

In a step S1b, a quantum dot light-emitting layer 130 is formed on a side of a second electrode 120.

In a step S2b, an electron transport adjustment layer 140 is formed on a side of the quantum dot light-emitting layer 130 away from the second electrode 120.

For example, the electron transport adjustment layer 140 is configured to adjust a number of electrons transported from the first electrode 110 to the quantum dot light-emitting layer 130.

In a step S3b, a first electrode 110 is formed on a side of the electron transport adjustment layer 140 away from the quantum dot light-emitting layer 130.

Here, for materials and formation processes of the second electrode 120, the quantum dot light-emitting layer 130, the electron transport adjustment layer 140 and the first electrode 110, reference may be made to the description of the steps S1a to S3a in some of the above embodiments, which will not be repeated here.

After the step S3b, the light-emitting device 100 may be encapsulated. For example, the light-emitting device 100 may be encapsulated by using ultraviolet curing adhesive.

The method for manufacturing a light-emitting device is used for manufacturing the light-emitting device 100 provided in some of the above embodiments. Beneficial effects that the method may achieve are same as the beneficial effects that the light-emitting device 100 provided in some of the above embodiments achieves, which will not be repeated here.

In some embodiments, the step that the electron transport adjustment layer 140 is formed on the side of the quantum dot light-emitting layer 130 away from the second electrode 120 includes steps S21b and S22b.

In a step S21b, an electron transport layer 141 is formed on the side of the quantum dot light-emitting layer 130 away from of the second electrode 120.

For example, a thickness of the electron transport layer 141 is in a range of 40 nm to 60 nm, inclusive. For example, the thickness of the electron transport layer 141 is 50 $\mu$m.

For example, the electron transport layer 141 may be formed by using a sol-gel method, a nanoparticle spin-coating method or a sputtering process.

In a step S22b, an electron adjustment layer 142 is formed on a side of the electron transport layer 141 away from the quantum dot light-emitting layer 130 by evaporation.

Here, for a material and a thickness of the electron adjustment layer 142, reference may be made to the description in some of the above embodiments, which will not be repeated here.

By forming the electron adjustment layer 142 by evaporation, the thickness of the electron adjustment layer 142 may be effectively controlled, so that an impact of an excessive thickness of the electron adjustment layer 142 on current efficiency of the light-emitting device is avoided.

In these embodiments, by forming the electron adjustment layer 142 by evaporation on the side of the electron transport layer 141 away from the quantum dot light-emitting layer 130, the number of electrons transported from the first electrode 110 to the quantum dot light-emitting layer 130 may be adjusted. In this way, the balance between electrons and holes in the quantum dot light-emitting layer 130 may be effectively promoted, which may effectively improve the light-emitting efficiency, and the stability and the service life of the light-emitting device 100.

In some other embodiments, the step that the electron transport adjustment layer 140 is formed on the side of the quantum dot light-emitting layer 130 away from the second electrode 120 includes: forming the electron transport adjustment layer 140 on the side of the quantum dot light-emitting layer 130 away from the second electrode 120 by a solution process.

Here, the electron transport adjustment layer 140 includes a dopant material 1402 and a host material 1401. The dopant material 1402 is configured to adjust the number of electrons transported from the first electrode 110 to the quantum dot light-emitting layer 130.

Here, the electron transport adjustment layer 140 may be formed by performing doping through an ion implantation method or a diffusion method.

For example, a specific step for forming the electron transport adjustment layer 140 on the side of the quantum dot light-emitting layer 130 away from the second electrode 120 by the solution process may include: adding molybdenum acetate (Mo $(CH_3COO)_2 \cdot 2H_2O$) to a solution of zinc acetate ($Zn(CH_3COO)_2 \cdot 2H_2O$) as a precursor solution using for preparing ZnO, adding an appropriate amount of a potassium hydroxide solution to the precursor solution, stirring at 60°C, and finally adding ethanolamine as a stabilizer, so that molybdenum doped ZnO nanoparticles may be obtained.

For example, the electron transport adjustment layer 140 includes the dopant material 1402 doped therein, and the dopant material 1402 is used for adjusting the number of electrons transported from the first electrode 110 to the quantum dot light-emitting layer 130. In this way, the balance between electrons and holes in the light-emitting device 100 may be effectively promoted, which may effectively improve the light-emitting efficiency, the stability and the service life of the light-emitting device 100.

The foregoing descriptions are merely specific implementations of the present disclosure. However, the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

**Claims**

1. A light-emitting device, comprising:

   a first electrode, an electron transport adjustment layer, a quantum dot light-emitting layer and a second electrode that are arranged in sequence, wherein
   the electron transport adjustment layer is configured to adjust a number of electrons transported from the first electrode to the quantum dot light-emitting layer.

2. The light-emitting device according to claim **1**, wherein the electron transport adjustment layer includes:

   an electron transport layer located between the first electrode and the quantum dot light-emitting layer; and
   an electron adjustment layer located between the electron transport layer and the first electrode, wherein
   a work function of the electron adjustment layer is greater than a work function of the electron transport layer, and the work function of the electron adjustment layer is greater than a work function of the first electrode; and
   the electron adjustment layer is configured to reduce the number of electrons transported from the first electrode to the quantum dot light-emitting layer.

3. The light-emitting device according to claim **2**, wherein
   the electron adjustment layer and the electron transport layer together include at least three elements, and the electron adjustment layer and the electron transport layer include at least one same element.

4. The light-emitting device according to any one of claims **2** to **3**, wherein the work function of the electron adjustment layer is E eV, and a thickness of the electron adjustment layer is D nm, wherein E and D satisfy:

$$1 < \frac{E}{D} < 23.33 \,.$$

5. The light-emitting device according to any one of claims **2** to **4**, wherein the work function of the electron adjustment layer is in a range of 5 eV to 7 eV, inclusive.

6. The light-emitting device according to any one of claims **2** to **5**, wherein an energy level of a highest occupied molecular orbital of the electron adjustment layer is in a range of -7 eV to -10 eV, inclusive; and
   an energy level of a lowest unoccupied molecular orbital of the electron adjustment layer is in a range of -4.2 eV to -6 eV, inclusive.

7. The light-emitting device according to any one of claims **2** to **6**, wherein a material of the electron adjustment layer includes an oxide of a metal of a fifth sub-group or an oxide of a metal of a sixth sub-group.

8. The light-emitting device according to any one of claims **2** to **7**, wherein a material of the electron adjustment layer includes at least one of $MoO_3$, $WO_3$, $V_2O_5$ or CrOs; and
a material of the electron transport layer includes at least one of ZnO, ZnS, ZnSe, ZnMgO, NiO, CdS, CdSe or CdO.

9. The light-emitting device according to any one of claims **2** to **8**, wherein an energy level of a lowest unoccupied molecular orbital of the electron transport adjustment layer is less than an energy level of a lowest unoccupied molecular orbital of the electron transport layer.

10. The light-emitting device according to any one of claims **2** to **9**, wherein a roughness of a surface of the electron adjustment layer away from the electron transport layer is less than a roughness of a surface of the electron transport layer away from the electron adjustment layer.

11. The light-emitting device according to claim **1**, wherein the electron transport layer includes:

   an electron transport layer located between the first electrode and the quantum dot light-emitting layer; and
   an electron adjustment layer located between the electron transport layer and the first electrode, wherein
   a work function of the electron adjustment layer is less than a work function of the electron transport layer, and
   the work function of the electron adjustment layer is less than a work function of the first electrode; and
   the electron adjustment layer is configured to increase the number of electrons transported from the first electrode to the quantum dot light-emitting layer.

12. The light-emitting device according to claim **11**, wherein a material of the electron adjustment layer includes $Cs_2O_3$.

13. The light-emitting device according to any one of claims **2** to **12**, wherein a thickness of the electron adjustment layer is in a range of 0.3 nm to 5 nm, inclusive.

14. The light-emitting device according to claim **1**, wherein

   the electron transport adjustment layer includes a dopant material and a host material; and
   the dopant material is configured to adjust the number of electrons transported from the first electrode to the quantum dot light-emitting layer.

15. The light-emitting device according to claim **14**, wherein the electron transport adjustment layer includes at least three elements, and the dopant material and the host material include at least one element same element.

16. The light-emitting device according to claim **14** or **15**, wherein a work function of the dopant material is greater than a work function of the host material, and the work function of the dopant material is greater than a work function of the first electrode; and
the dopant material is configured to reduce the number of electrons transported from the first electrode to the quantum dot light-emitting layer.

17. The light-emitting device according to any one of claims **14** to **16**, the dopant material includes a P-type dopant material.

18. The light-emitting device according to claim **17**, wherein the P-type dopant material includes at least one of $MoO_3$, $WO_3$, $V_2O_5$ or $CrO_3$.

19. The light-emitting device according to any one of claims **1** to **18**, further comprising:

   a hole transport layer, located between the second electrode and the quantum dot light-emitting layer; and
   a hole injection layer, located between the second electrode and the hole transport layer.

20. A method for manufacturing a light-emitting device, the method comprising:

   forming an electron transport adjustment layer on a side of a first electrode,
   forming a quantum dot light-emitting layer on a side of the electron transport adjustment layer away from the first electrode, and
forming a second electrode on a side of the quantum dot light-emitting layer away from the electron transport adjustment layer;
or
forming the quantum dot light-emitting layer on a side of the second electrode,
forming the electron transport adjustment layer on a side of the quantum dot light-emitting layer away from the second electrode, and
forming the first electrode on a side of the electron transport adjustment layer away from the quantum dot light-emitting layer,
wherein the electron transport adjustment layer is configured to adjust a number of electrons transported from the first electrode to the quantum dot light-emitting layer.

21. The method according to claim **20**, wherein forming the electron transport adjustment layer on the side of the first electrode includes:

forming an electron adjustment layer by evaporation; and
forming an electron transport layer on a side of the electron adjustment layer away from the first electrode;
or
forming the electron transport layer on the side of the quantum dot light-emitting layer away from the second electrode, and
forming the electron adjustment layer on a side of the electron transport layer away from the quantum dot light-emitting layer by evaporation.

22. The method according to claim **20**, wherein forming the electron transport adjustment layer on the side of the first electrode includes:

forming the electron transport adjustment layer on the side of the first electrode by a solution process;
or
forming the electron transport adjustment layer on the side of the quantum dot light-emitting layer away from the second electrode by a solution process,
wherein the electron transport adjustment layer includes a dopant material and a host material, and the dopant material is configured to adjust the number of electrons transported from the first electrode to the quantum dot light-emitting layer.

23. A display panel, comprising:

a backplane; and
a plurality of light-emitting devices each according to any one of claims **1** to **19**, the plurality of light-emitting devices being disposed on a side of the backplane.

24. The display panel according to claim **23**, wherein a first electrode of a light-emitting device is closer to the backplane than a second electrode of the light-emitting device; or
the second electrode of the light-emitting device is closer to the backplane than the first electrode of the light-emitting device.

25. A display apparatus, comprising the display panel according to claim **23** or **24**.

2000

FIG. 1

1000

P    BB    AA

Y
X

FIG. 2

1000

300

310  320  330

110 130 120

100

220

P

210        400

200

**FIG. 3**

100

110

142
140
141

130

150

160

120

**FIG. 4A-1**

100

FIG. 4A-2

FIG. 4B

FIG. 5

FIG. 6

FIG. 7

FIG. 8

FIG. 9A

FIG. 9B

FIG. 10A

FIG. 10B

FIG. 11A

FIG. 11B

ZnO

ZnO+1nmMoO$_3$

ZnO+7nmMoO$_3$

FIG. 12A

FIG. 12B

FIG. 12C

FIG. 12D

FIG. 13A

FIG. 13B

FIG. 14A

FIG. 14B

FIG. 15

<u>100</u>

**FIG. 16**

| An electron transport adjustment layer is formed on a side of the first electrode | S1a |
| A quantum dot light-emitting layer is formed on a side of the electron transport adjustment layer away from the first electrode | S2a |
| A second electrode is formed on a side of the quantum dot light-emitting layer away from the electron transport adjustment layer | S3a |

**FIG. 17**

| A quantum dot light-emitting layer is formed on a side of a second electrode | S1b |
| An electron transport adjustment layer is formed on a side of the quantum dot light-emitting layer away from the second electrode | S2b |
| A first electrode is formed on a side of the electron transport adjustment layer away from the quantum dot light-emitting layer | S3b |

**FIG. 18**

| INTERNATIONAL SEARCH REPORT | International application No. |
|---|---|
| | **PCT/CN2022/115412** |

**A. CLASSIFICATION OF SUBJECT MATTER**

H10K50/115(2023.01)i

According to International Patent Classification (IPC) or to both national classification and IPC

**B. FIELDS SEARCHED**

Minimum documentation searched (classification system followed by classification symbols)

IPC: H10K

Documentation searched other than minimum documentation to the extent that such documents are included in the fields searched

Electronic data base consulted during the international search (name of data base and, where practicable, search terms used)

CNABS; CNTXT; CNKI; VEN; USTXT; WOTXT; EPTXT: 京东方, 电子, 载流子, 电荷, 注入, 平衡, 势垒, 量子点, 功函数, electron, carrier, charge, inject+, balance, barrier, quantum dot, work function

**C. DOCUMENTS CONSIDERED TO BE RELEVANT**

| Category* | Citation of document, with indication, where appropriate, of the relevant passages | Relevant to claim No. |
|---|---|---|
| X | CN 108735905 A (TCL CORP.) 2018-11-02 (2018-11-02) description, paragraphs [0005]-[0051], and figure 2 | 1-25 |
| X | CN 113851594 A (HEFEI FUNA TECHNOLOGY CO., LTD.) 2021-12-28 (2021-12-28) description, paragraphs [0004]-[0088] | 1-25 |
| X | WO 2021226818 A1 (BOE TECHNOLOGY GROUP CO., LTD. et al.) 2021-11-18 (2021-11-18) description, page 1, line 20 to page 24, line 22, and figure 3 | 1-25 |
| X | CN 112802973 A (GUANGDONG JUHUA PRINTING DISPLAY TECHNOLOGY CO., LTD.) 2021-05-14 (2021-05-14) description, paragraphs [0004]-[0115], and figure 1 | 1-25 |
| A | CN 113130833 A (TCL CORP.) 2021-07-16 (2021-07-16) entire document | 1-25 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **03 April 2023** | **20 April 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

International application No.

**PCT/CN2022/115412**

| Patent document cited in search report | | | Publication date (day/month/year) | Patent family member(s) | | | Publication date (day/month/year) |
|---|---|---|---|---|---|---|---|
| CN | 108735905 | A | 02 November 2018 | CN | 108735905 | B | 19 February 2021 |
| CN | 113851594 | A | 28 December 2021 | | None | | |
| WO | 2021226818 | A1 | 18 November 2021 | US | 2022123168 | A1 | 21 April 2022 |
| | | | | KR | 20230009866 | A | 17 January 2023 |
| | | | | CN | 114026703 | A | 08 February 2022 |
| CN | 112802973 | A | 14 May 2021 | | None | | |
| CN | 113130833 | A | 16 July 2021 | WO | 2021136044 | A1 | 08 July 2021 |

Form PCT/ISA/210 (patent family annex) (July 2022)